# EUROPEAN PATENT APPLICATION

(11) **EP 4 274 400 A1**
(43) Date of publication of application: **08.11.2023**
(21) Application number: 23156274.5
(22) Date of filing: 13.02.2023
(51) Int. Cl.: H10B 12/00, H01L 29/786

(54) **SEMICONDUCTOR DEVICE**

(30) Priority: 02.05.2022 KR 20220054409
(71) Applicant: Samsung Electronics Co., Ltd., Suwon-si, Gyeonggi-do 16677 (KR)
(72) Inventor: LEE, Kiseok, 16677 Suwon-si (KR); KU, Byeongjoo, 16677 Suwon-si (KR); KIM, Keunnam, 16677 Suwon-si (KR); LEE, Wonsok, 16677 Suwon-si (KR); JEONG, Moonyoung, 16677 Suwon-si (KR); CHO, Min Hee, 16677 Suwon-si (KR)
(74) Representative: Marks & Clerk LLP

(57) **Abstract**

A semiconductor device may include a bit line extending in a first direction, a semiconductor pattern on the bit line, the semiconductor pattern including first and second vertical portions, which are opposite to each other in the first direction, first and second word lines adjacent to the first and second vertical portions, respectively, and a gate insulating pattern between the first vertical portion and the first word line and between the second vertical portion and the second word line. A bottom surface of the first and second vertical portions is located at a height that is lower than or equal to the uppermost surface of the bit line.

## Description

### BACKGROUND OF THE INVENTION

The present disclosure relates to a semiconductor device, and in particular, to a semiconductor device including vertical channel transistors and a method of fabricating the same.

As a semiconductor device is scaled down, it is necessary to develop a fabrication technology capable of increasing an integration density of a semiconductor device and improving an operation speed and a production yield. Thus, semiconductor devices with vertical channel transistors have been suggested to increase an integration density of a semiconductor device and improve resistance and current driving characteristics of the transistor.

### SUMMARY

An example embodiment of the inventive concepts provides a semiconductor device with improved electric and reliability characteristics.

According to an example embodiment of the inventive concepts, a semiconductor device may include a bit line extending in a first direction, a semiconductor pattern on the bit line, the semiconductor pattern including first and second vertical portions, which are opposite to each other in the first direction, and a horizontal portion connecting the first and second vertical portions, first and second word lines on the horizontal portion to be adjacent to the first and second vertical portions, respectively, and a gate insulating pattern between the first vertical portion and the first word line and between the second vertical portion and the second word line. A bottom surface of the horizontal portion may be located at a height that is lower than or equal to the uppermost surface of the bit line.

According to an example embodiment of the inventive concepts, a semiconductor device may include a bit line extending in a first direction, a semiconductor pattern on the bit line, the semiconductor pattern including first and second vertical portions, which are spaced apart from and opposite to each other in the first direction, first and second word lines on inner side surfaces of the first and second vertical portions, respectively, and a gate insulating pattern between the first vertical portion and the first word line and between the second vertical portion and the second word line. Bottom surfaces of the first and second vertical portions may be located at a height that is lower than or equal to the uppermost surface of the bit line.

According to an example embodiment of the inventive concepts, a semiconductor device may include a bit line extending in a first direction, a semiconductor pattern on the bit line, the semiconductor pattern including first and second vertical portions, which are spaced apart from and opposite to each other in the first direction, first and second word lines on inner side surfaces of the first and second vertical portions, respectively, and a gate insulating pattern between the first vertical portion and the first word line and between the second vertical portion and the second word line. Bottom surfaces of the first and second vertical portions may be located at a height higher than a bottom surface of the gate insulating pattern.

At least some of the above and other features of the invention are set out in the claims.

### BRIEF DESCRIPTION OF THE DRAWINGS

FIG. 1 is a block diagram illustrating a semiconductor memory device including a semiconductor device according to an example embodiment of the inventive concepts.
FIG. 2 is a perspective view schematically illustrating a semiconductor device according to an example embodiment of the inventive concepts.
FIG. 3 is a plan view illustrating a semiconductor device according to an example embodiment of the inventive concepts.
FIGS. 4 to 6 are sectional views which are respectively taken along lines A-A', B-B', and C-C' of FIG. 3.
FIGS. 7A to 7D, 8A to 8D, 9A to 9D, 10A to 10D, 11A to 11D, and 12A to 12D are sectional views, each of which is taken along a line D-D' of FIG. 3.
FIGS. 13A to 13E are sectional views illustrating a method of fabricating the semiconductor device of FIG. 7A.
FIGS. 14A and 14B are sectional views illustrating a method of fabricating the semiconductor device of FIG. 8A.
FIG. 15 is a sectional view illustrating a method of fabricating the semiconductor device of FIG. 9A.
FIG. 16 is a sectional view illustrating a method of fabricating the semiconductor device of FIG. 11A.

### DETAILED DESCRIPTION

Example embodiments of the inventive concepts will now be described more fully with reference to the accompanying drawings, in which example embodiments are shown.

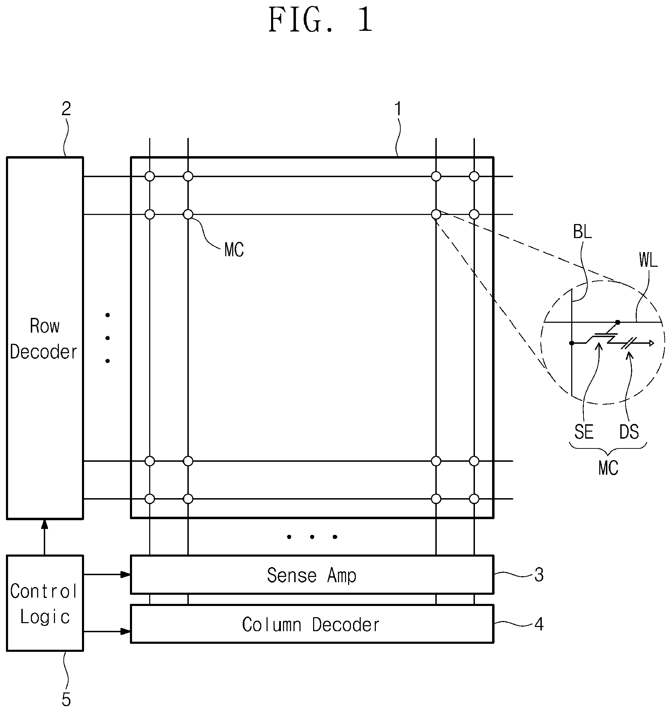

FIG. 1 is a block diagram illustrating a semiconductor memory device including a semiconductor device according to an example embodiment of the inventive concepts.

Referring to FIG. 1, a semiconductor memory device may include a memory cell array 1, a row decoder 2, a sense amplifier 3, a column decoder 4, and a control logic 5.

The memory cell array 1 may include a plurality of memory cells MC, which are two- or three-dimensionally arranged. Each of the memory cells MC may be disposed between and connected to a word line WL and a bit line BL crossing each other.

Each of the memory cells MC may include a selection element SE and a data storage element DS, which are electrically connected to each other in series. The selection element SE may be disposed between and connected to the data storage element DS and the word line WL, and the data storage element DS may be connected to the bit line BL through the selection element SE. The selection element SE may be a field effect transistor (FET), and the data storage element DS may be realized by a capacitor, a magnetic tunnel junction pattern, or a variable resistor. As an example, the selection element SE may include a transistor, a gate electrode of the transistor may be connected to the word line WL, and drain/source terminals of the transistor may be connected to the bit line BL and the data storage element DS, respectively.

The row decoder 2 may be configured to decode address information, which is input from the outside, and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may provide a data transmission path between the sense amplifier 3 and an external device (e.g., a memory controller). The column decoder 4 may be configured to decode address information, which is input from the outside, and to select one of the bit lines BL, based on the decoded address information.

The control logic 5 may generate control signals, which are used to control writing or reading operations on the memory cell array 1.

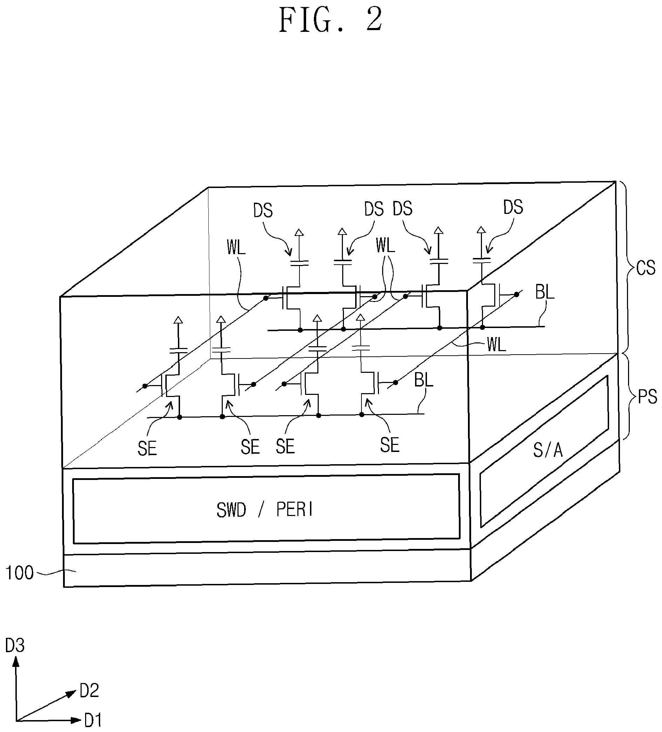

FIG. 2 is a perspective view schematically illustrating a semiconductor device according to an example embodiment of the inventive concepts.

Referring to FIG. 2, a semiconductor device according to an example embodiment of the inventive concepts may include a substrate 100, a peripheral circuit structure PS on the substrate 100, and a cell array structure CS on the peripheral circuit structure PS.

The peripheral circuit structure PS may include core and peripheral circuits formed on the substrate 100. The core and peripheral circuits may include the row and column decoders 2 and 4, the sense amplifier 3, and the control logic 5 described with reference to FIG. 1. The peripheral circuit structure PS may be provided between the substrate 100 and the cell array structure CS, in a third direction D3 perpendicular to a top surface of the substrate 100.

The cell array structure CS may include the bit lines BL, the word lines WL, and the memory cells MC therebetween (e.g., see FIG. 1). The memory cells MC (e.g., see FIG. 1) may be two- or three-dimensionally arranged on a plane that is parallel to the top surface of the substrate 100 and is extended in two different directions (e.g., first and second directions D1 and D2). Each of the memory cells MC (e.g., see FIG. 1) may include the selection element SE and the data storage element DS, as described above.

In an example embodiment, each of the memory cells MC (e.g., see FIG. 1) may include a vertical channel transistor (VCT), which is used as the selection element SE. The vertical channel transistor may be configured to include a channel region that is extended in a direction (i.e., the third direction D3) perpendicular to the top surface of the substrate 100. In addition, each of the memory cells MC (e.g., see FIG. 1) may include a capacitor, which is used as the data storage element DS.

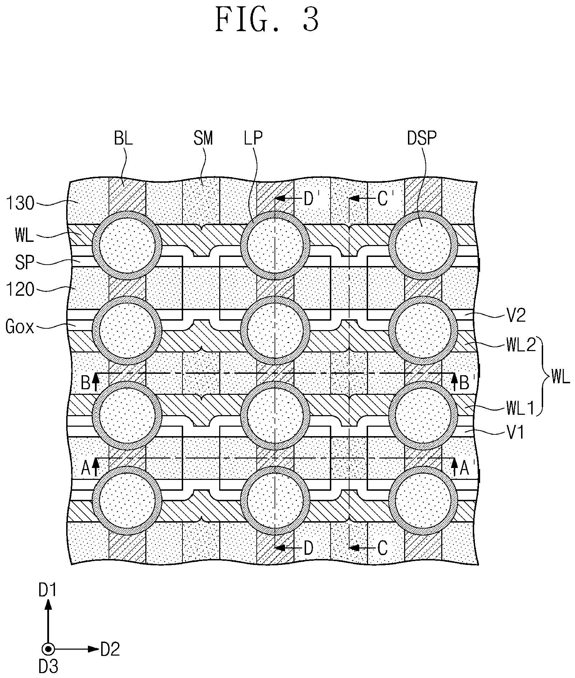

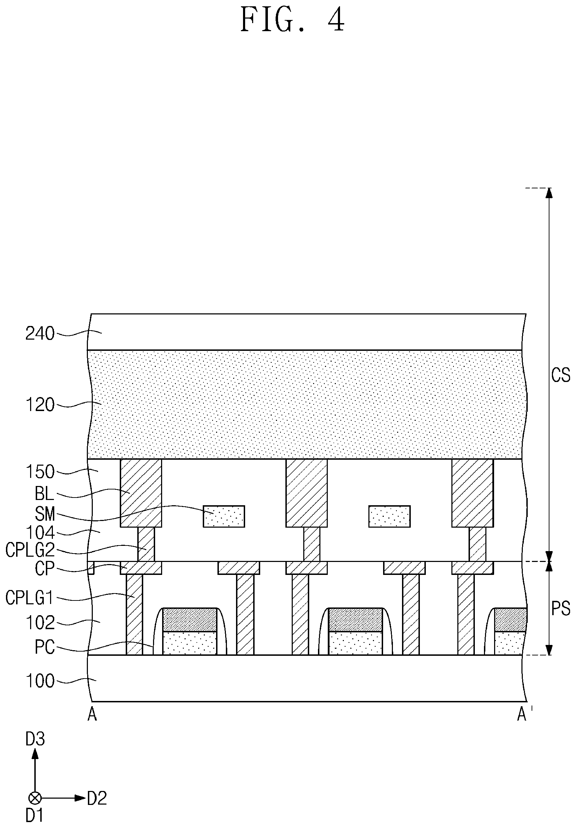

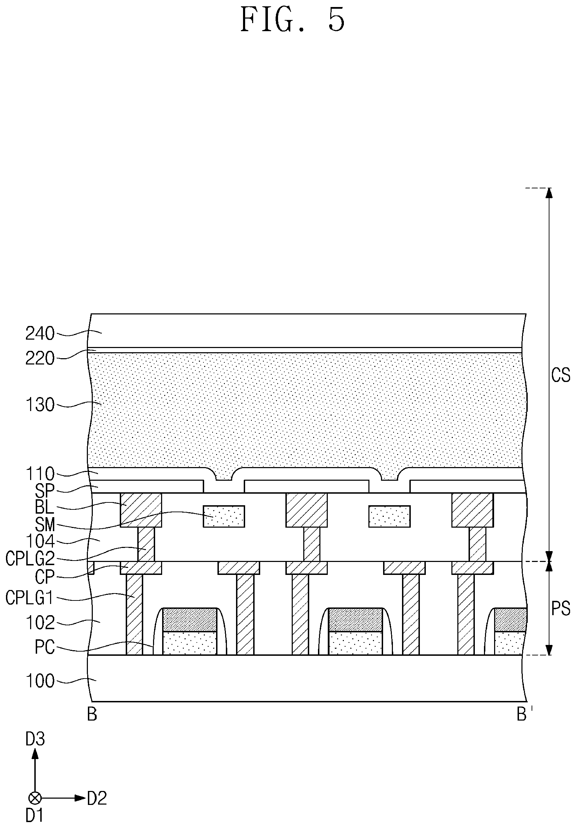

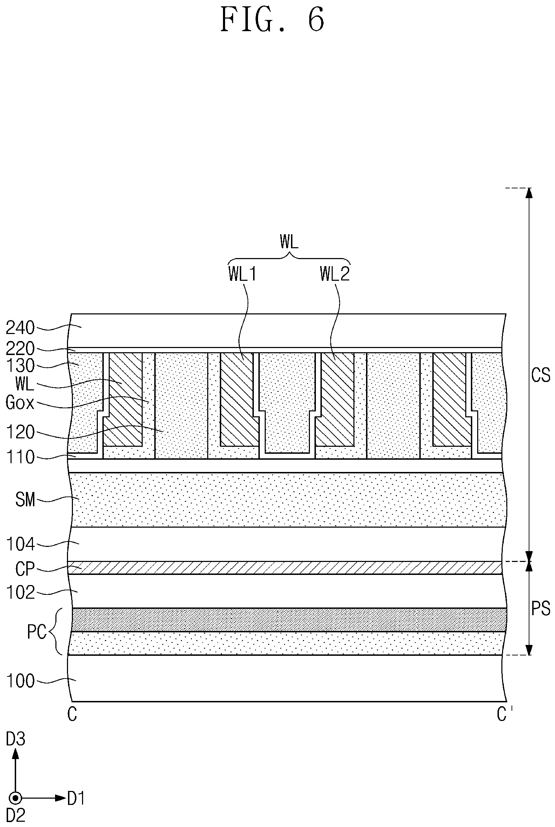

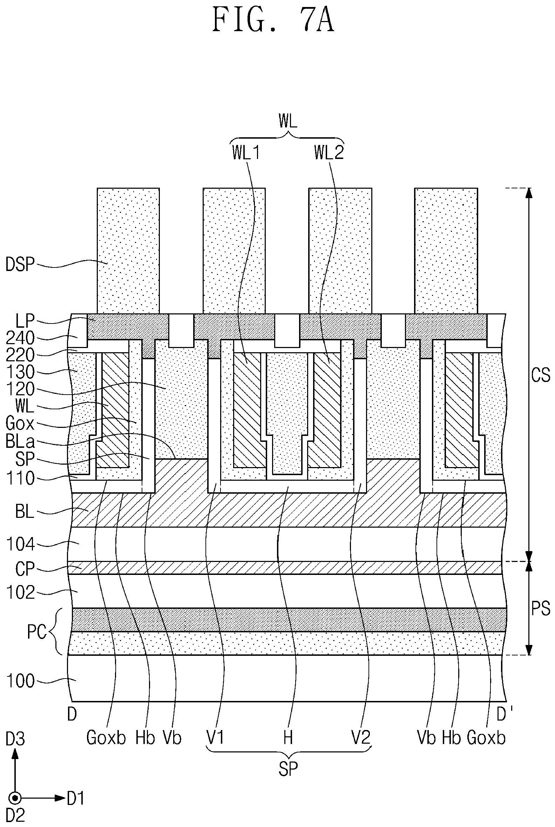

FIG. 3 is a plan view illustrating a semiconductor device according to an example embodiment of the inventive concepts. FIGS. 4 to 6 are sectional views which are respectively taken along lines A-A', B-B', and C-C' of FIG. 3. FIGS. 7A to 7D are sectional views, each of which is taken along a line D-D' of FIG. 3.

Referring to FIGS. 3 to 6 and 7A to 7D, the semiconductor device may include the substrate 100, the peripheral circuit structure PS on the substrate 100, and the cell array structure CS on the peripheral circuit structure PS.

The substrate 100 may be a semiconductor substrate. For example, the substrate 100 may be a silicon substrate, a germanium substrate, or a silicon-germanium substrate.

The peripheral circuit structure PS may include a peripheral gate structure PC, which is integrated on the substrate 100, peripheral contact pads CP, peripheral contact plugs CPLG1, and a first interlayer insulating layer 102 covering them. The peripheral gate structure PC may include the sense amplifier 3 of FIG. 1.

The cell array structure CS may include memory cells including vertical channel transistors. The cell array structure CS may include a plurality of cell contact plugs CPLG2, a plurality of bit lines BL, a plurality of shielding structures SM, a second interlayer insulating layer 104, a plurality of semiconductor patterns SP, a plurality of word lines WL, a plurality of gate insulating patterns Gox, and data storage patterns DSP. The second interlayer insulating layer 104 may cover the cell contact plugs CPLG2 and the shielding structures SM.

As an example, the peripheral gate structures PC of the peripheral circuit structure PS may be electrically connected to the bit lines BL through the peripheral contact plugs CPLG1, the peripheral contact pads CP, and the cell contact plugs CPLG2. In an example embodiment, each of the first and second interlayer insulating layers 102 and 104 may include a plurality of insulating layers stacked in a multi-layered structure and may be formed of or include at least one of silicon oxide, silicon nitride, silicon oxynitride, or low-k dielectric materials.

The bit lines BL may be provided on the substrate 100 and may be extended in the first direction D1. A plurality of the bit lines BL may be provided, and here, the bit lines BL may be spaced apart from each other in the second direction D2. The bit lines BL may be electrically connected to the peripheral contact pads CP through the cell contact plugs CPLG2.

In an example embodiment, the bit line BL may be formed of or include at least one of doped polysilicon, metallic materials (e.g., Al, Cu, Ti, Ta, Ru, W, Mo, Pt, Ni, and Co), conductive metal nitride materials (e.g., TiN, TaN, WN, NbN, TiAlN, TiSiN, TaSiN, and RuTiN), conductive metal silicide materials, or conductive metal oxide materials (e.g., PtO, RuOz, IrO₂, SrRuO₃ (SRO), (Ba,Sr)RuO₃ (BSRO), CaRuO₃ (CRO), and LSCo), but the inventive concepts are not limited to this example. The bit line BL may be a single- or multi-layered structure formed of the afore-described materials. In an example embodiment, the bit line BL may be formed of or include at least one of two-dimensional semiconductor materials (e.g., graphene, carbon nanotube, or combinations thereof).

The shielding structures SM may be respectively provided between the bit lines BL and may be extended in the first direction D 1. The shielding structures SM may be formed of or include at least one of conductive materials (e.g., metallic materials). The shielding structures SM may be provided in the second interlayer insulating layer 104, and top surfaces of the shielding structures SM may be located at a height lower than the uppermost surfaces BLa of the bit lines BL.

As an example, the shielding structures SM may be formed of or include a conductive material, and an air gap or void may be formed in the shielding structure SM. As another example, although not shown, the air gaps may be provided in the second interlayer insulating layer 104 instead of the shielding structures SM.

The semiconductor pattern SP may be disposed on the bit line BL. In an example embodiment, a plurality of the semiconductor patterns SP may be provided. The semiconductor patterns SP may be spaced apart from each other in the first and second directions D1 and D2.

With reference to FIGS. 7A-7D, the semiconductor pattern SP may include a first vertical portion V1 and a second vertical portion V2, which are opposite to each other, and a horizontal portion H, which connects the first and second vertical portions V1 and V2 to each other. The horizontal portion H may be placed near lower portions of the first and second vertical portions V1 and V2 to connect the first and second vertical portions V1 and V2 to each other.

The bit line BL may have an uneven top surface. A top surface of the bit line BL below the semiconductor pattern SP may be located at a height lower than the uppermost surface BLa of the bit line BL. The uppermost surface BLa of the bit line BL may be a portion of the top surface of the bit line BL, which is located at the highest level and is provided on a region that is not overlapped with the semiconductor pattern SP vertically.

A bottom surface Hb of the horizontal portion H of the semiconductor pattern SP may be located at a height lower than the uppermost surface BLa of the bit line BL. As an example, the bottom surface Hb of the horizontal portion H may be a portion of the bottom surface of the horizontal portion H located at the lowermost level, but the inventive concepts are not limited to this example. At least a portion of the horizontal portion H may be buried or received in an upper portion of the bit line BL. As an example, a top surface of the horizontal portion H may be located at a height lower than the uppermost surface BLa of the bit line BL, as shown in FIGS. 7A to 7D, but the inventive concepts are not limited to this example. As another example, although not shown, the top surface of the horizontal portion H may be located at a height that is higher than or equal to the uppermost surface BLa of the bit line BL.

Lower portions of the first and second vertical portions V1 and V2 may be buried or received in the upper portion of the bit line BL. Bottom surfaces Vb of the first and second vertical portions V1 and V2 may be substantially coplanar with the bottom surface Hb of the horizontal portion H and may be located at a height lower than the uppermost surface BLa of the bit line BL. As an example, each of the bottom surfaces Vb of the first and second vertical portions V1 and V2 may be the lowermost portion of each of the bottom surfaces Vb of the first and second vertical portions V1 and V2, but the inventive concepts are not limited to this example. Outer side surfaces of the lower portions of the first and second vertical portions V1 and V2 may be enclosed by the bit line BL.

The horizontal portion H of the semiconductor pattern SP may include a common source/drain region. An upper portion of the first vertical portion V1 may include a first source/drain region and an upper portion of the second vertical portion V2 may include a second source/drain region. The first vertical portion V1 may include a first channel region between the common source/drain region and the first source/drain region, and the second vertical portion V2 may include a second channel region between the common source/drain region and the second source/drain region. Each of the first and second vertical portions V1 and V2 may be electrically connected to the bit line BL. That is, the semiconductor device may have a structure, in which a pair of vertical channel transistors share one bit line BL.

The semiconductor pattern SP may be formed of or include at least one of oxide semiconductor materials (e.g., InxGayZnzO, InxGaySizO, InxSnyZnzO, InxZnyO, ZnxO, ZnxSnyO, ZnxOyN, ZrxZnySnzO, SnxO, HfxInyZnzO, GaxZnySnzO, AlxZnySnzO, YbxGayZnzO, and InxGayO), but the inventive concepts are not limited to this example. In an example embodiment, the semiconductor pattern SP may include Indium Gallium Zinc Oxide (IGZO). The semiconductor pattern SP may have a single- or multi-layered structure that is made of the oxide semiconductor material. The semiconductor pattern SP may include an amorphous, crystalline, or polycrystalline oxide semiconductor material. In an example embodiment, the semiconductor pattern SP may have a band gap energy that is greater than that of silicon. For example, the semiconductor pattern SP may have a band gap energy of about 1.5 eV to 5.6 eV. When the semiconductor pattern SP has a band gap energy of about 2.0 eV to 4.0 eV, the semiconductor pattern SP may have optimized channel performance. For example, the semiconductor pattern SP may have a polycrystalline or amorphous structure, but the inventive concepts are not limited to this example. In an example embodiment, the semiconductor pattern SP may include a two-dimensional semiconductor material, and here, the two-dimensional semiconductor material may include graphene, carbon nanotube, or combinations thereof.

The word line WL may be disposed between the first vertical portion V1 and the second vertical portion V2. In an example embodiment, a plurality of the word lines WL may be provided. The word lines WL may be extended in the second direction D2 and may be spaced apart from each other in the first direction D1.

Each of the word lines WL may include a first word line WL1 and a second word line WL2, and the first and second word lines WL1 and WL2 may be opposite to each other in the first direction D1. The first word line WL1 may cover an inner side surface of the first vertical portion V1 facing the second vertical portion V2.

The first word line WL1 may be placed near the first channel region of the first vertical portion V1 and may be used to control the first channel region. The second word line WL2 may be placed near an inner side surface of the second vertical portion V2 facing the first vertical portion V1. The second word line WL2 may be placed near the second channel region of the second vertical portion V2 and may be used to control the second channel region.

Due to an uneven structure of the bit line BL, a portion of the word line WL may be buried or received in an upper portion of the bit line BL. Accordingly, the buried portion of the word line WL may be horizontally overlapped with the bit line BL. Thus, the word line WL may be used to effectively control a lower portion of each of the first and second channel regions (e.g., a lower portion of each of the first and second channel regions located at a height lower than the uppermost surface BLa of the bit line BL), and thus, electrical and reliability characteristics of a semiconductor device may be improved.

In an example embodiment, lower portions of the first and second word lines WL1 and WL2 may protrude toward each other. In this case, a width of the lower portions of the first and second word lines WL1 and WL2 in the first direction D1 may be larger than a width of upper portions of the first and second word lines WL1 and WL2. However, the inventive concepts are not limited to this example, and in an example embodiment, although not shown, the upper/lower portions of the first and second word lines WL1 and WL2 may be provided to have substantially the same width.

The word line WL may be formed of or include at least one of doped polysilicon, metallic materials (e.g., Al, Cu, Ti, Ta, Ru, W, Mo, Pt, Ni, and Co), conductive metal nitride materials (e.g., TiN, TaN, WN, NbN, TiAlN, TiSiN, TaSiN, and RuTiN), conductive metal silicide materials, or conductive metal oxide materials (e.g., PtO, RuO₂, IrO₂, SrRuO₃ (SRO), (Ba,Sr)RuO₃ (BSRO), CaRuO₃ (CRO), and LSCo), but the inventive concepts are not limited to this example. The word line WL may be a single- or multi-layered structure formed of the afore-described materials. In an example embodiment, the word line WL may be formed of or include at least one of two-dimensional semiconductor materials (e.g., graphene and carbon nanotube) or combinations thereof.

The gate insulating pattern Gox may be interposed between the semiconductor pattern SP and the word line WL. In detail, the gate insulating pattern Gox may be interposed between the inner side surface of the first vertical portion V1 and the first word line WL1 and between the inner side surface of the second vertical portion V2 and the second word line WL2. The gate insulating pattern Gox may be extended into a region between the horizontal portion H and the word line WL. The word line WL may be spaced apart from the semiconductor pattern SP by the gate insulating pattern Gox. The gate insulating pattern Gox may cover the semiconductor pattern SP to a uniform thickness.

In an example embodiment, as shown in FIGS. 7A to 7D, a plurality of the gate insulating patterns Gox may be respectively interposed between the first vertical portion V1 and the first word line WL1 and between the second vertical portion V2 and the second word line WL2 and may be separated from each other on the horizontal portion H. That is, the gate insulating patterns Gox may be spaced apart from each other on the horizontal portion H.

In another example embodiment, although not shown, the gate insulating pattern Gox may be interposed between the first vertical portion V1 and the first word line WL1 and between the second vertical portion V2 and the second word line WL2, may be extended to a region on the horizontal portion H, and may be connected to each other.

The gate insulating pattern Gox may be formed of or include at least one of silicon oxide, silicon oxynitride, or high-k dielectric materials whose dielectric constants are higher than that of silicon oxide. The dielectric material may include metal oxide materials or metal oxynitride materials. For example, the high-k dielectric material for the gate insulating pattern Gox may include at least one of HfO₂, HfSiO, HfSiON, Hf IaO, HfTiO, HfZrO, ZrO₂, or Al₂O₃, but the inventive concepts are not limited to this example.

A first insulating pattern 120 may be interposed between the semiconductor patterns SP, which are adjacent to each other in the first direction D1. In an example embodiment, a plurality of the first insulating patterns 120 may be provided. The first insulating patterns 120 may be extended in the second direction D2 to cross the bit line BL and may be spaced apart from each other in the first direction D1. The first insulating pattern 120 may cover at least a portion of outer side surfaces of the first and second vertical portions V1 and V2. In an example embodiment, the first insulating pattern 120 may be formed of or include at least one of silicon oxide, silicon nitride, silicon oxynitride, or low-k dielectric materials. In an example embodiment, the first insulating pattern 120 may have a single- or multi-layered structure.

In an example embodiment, as shown in FIG. 7A, the first insulating pattern 120 may be in contact with the uppermost surface BLa of the bit line BL. The first insulating pattern 120 may cover portions of the outer side surfaces of the first and second vertical portions V1 and V2 which are not buried or received in the bit line BL. The bottom surface Hb of the horizontal portion H of the semiconductor pattern SP may be located at a height lower than the lowermost bottom surface of the first insulating pattern 120.

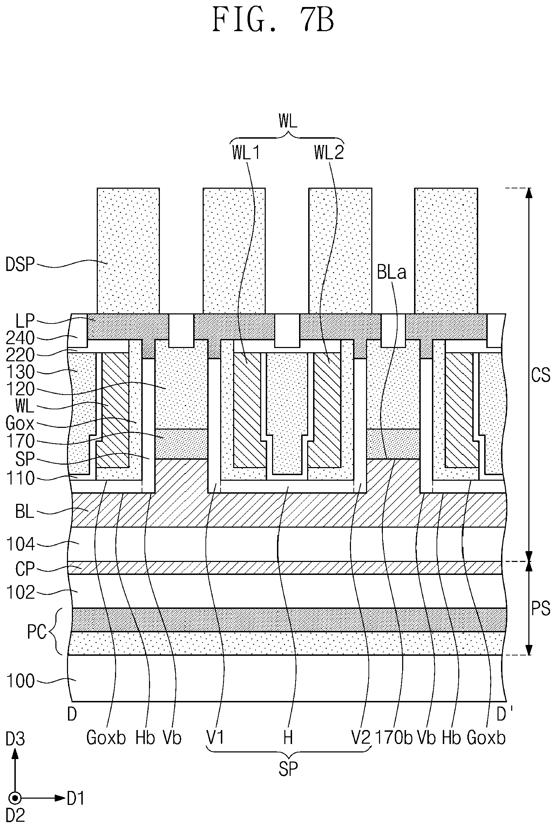

As another example, a blocking pattern 170 may be interposed between the first insulating pattern 120 and the bit line BL, as shown in FIG. 7B. The blocking pattern 170 may be interposed between the adjacent ones of the semiconductor patterns SP. The blocking pattern 170 may be disposed on the bit line BL to be adjacent to lower portions of the adjacent ones of the semiconductor patterns SP. In an example embodiment, a plurality of the blocking patterns 170 may be provided. As an example, adjacent ones of the blocking patterns 170 may be spaced apart from each other in the first direction D1 and may be respectively disposed at both sides of the semiconductor pattern SP. The blocking pattern 170 may be provided to vertically separate the first insulating pattern 120 from the bit line BL. The bottom surface Hb of the horizontal portion H of the semiconductor pattern SP may be located at a height lower than the lowermost surface 170b of the blocking pattern 170. The blocking pattern 170 may be formed of or include at least one of insulating and conductive materials. The insulating material may include at least one of silicon nitride (e.g., SiNx) or metal oxide materials (e.g., AlOx). For example, the conductive material may be formed of or include at least one of metallic materials.

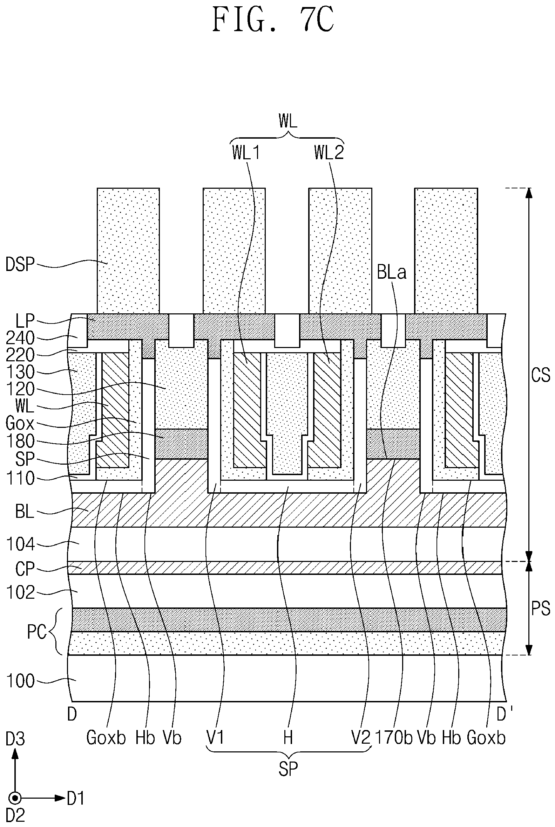

As still another example, a lower pattern 180 may be interposed between the first insulating pattern 120 and the bit line BL, as shown in FIG. 7C. The lower pattern 180 may be interposed between the adjacent ones of the semiconductor patterns SP. The lower pattern 180 may be disposed on the bit line BL to be adjacent to the lower portions of the adjacent ones of the semiconductor patterns SP. In an example embodiment, a plurality of the lower patterns 180 may be provided. As an example, adjacent ones of the lower patterns 180 may be spaced apart from each other in the first direction D1 and may be respectively disposed at both sides of the semiconductor pattern SP. The lower pattern 180 may be provided to vertically separate the first insulating pattern 120 from the bit line BL. The bottom surface Hb of the horizontal portion H of the semiconductor pattern SP may be located at a height lower than the lowermost surface 180b of the lower pattern 180. The lower pattern 180 may include at least one of hydrogen (H) or deuterium (D). For example, the lower pattern 180 may include silicon oxide that contains at least one of hydrogen or deuterium.

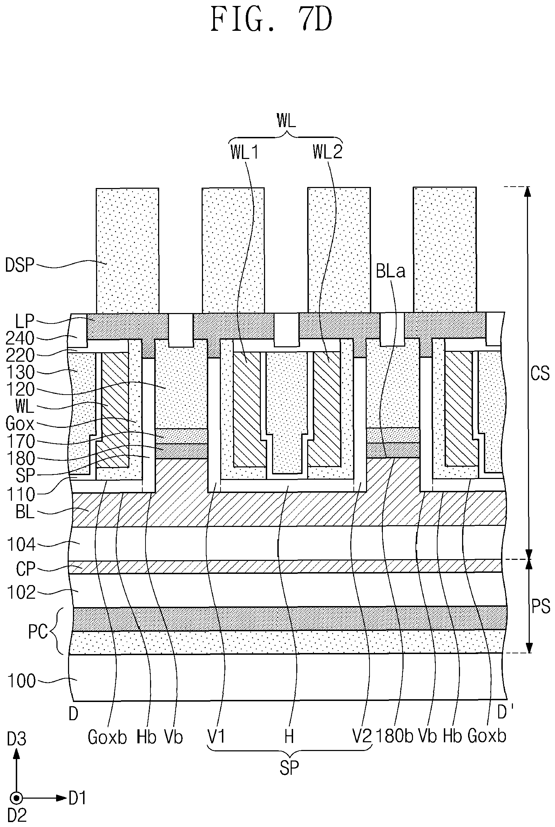

As yet other example, not only the blocking pattern 170 but also the lower pattern 180 may be interposed between the first insulating pattern 120 and the bit line BL, as shown in FIG. 7D. The blocking and lower patterns 170 and 180 may be interposed between the adjacent ones of the semiconductor patterns SP and may be disposed on the bit line BL to be adjacent to the lower portions of the adjacent ones of the semiconductor patterns SP. As an example, the lower pattern 180 may be located at a level lower than the blocking pattern 170 and may be interposed between the bit line BL and the blocking pattern 170. In this case, the bottom surface Hb of the horizontal portion H of the semiconductor pattern SP may be located at a height lower than the lowermost surface 180b of the lower pattern 180. However, the inventive concepts are not limited to this example, and in an example embodiment, although not shown, the stacking shape of the blocking and lower patterns 170 and 180 may be variously changed.

The blocking pattern 170 may prevent the lower portions of the first and second vertical portions V1 and V2 from being oxidized by oxygen (O) atoms in the first insulating pattern 120. Accordingly, it may be possible to reduce a contact resistance between the bit line BL and the semiconductor pattern SP and thereby to improve electrical and reliability characteristics of the semiconductor device.

The hydrogen or deuterium of the lower pattern 180 may be diffused into the lower portion of the semiconductor pattern SP to cure a defect in a crystalline structure of the lower portion of the semiconductor pattern SP. Accordingly, it may be possible to reduce a contact resistance between the bit line BL and the semiconductor pattern SP and thereby to improve the electrical and reliability characteristics of the semiconductor device.

Referring back to FIGS. 3 to 6 and 7A to 7D, a second insulating pattern 130 may be disposed between the first and second word lines WL1 and WL2 of the word line WL. In an example embodiment, a plurality of the second insulating patterns 130 may be provided. The second insulating patterns 130 may be extended in the second direction D2 to cross the bit line BL and may be spaced apart from each other in the first direction D1. The first and second insulating patterns 120 and 130 may be alternately arranged in the first direction D1. The second insulating pattern 130 may be formed of or include at least one of silicon oxide, silicon nitride, silicon oxynitride, or low-k dielectric materials.

A protection pattern 110 may be interposed between the word line WL and the second insulating pattern 130. The protection pattern 110 may be provided to cover an inner side surface of the word line WL. The protection pattern 110 may be formed of or include at least one of silicon oxide, silicon nitride, or silicon oxynitride.

A capping pattern 220 may be provided on a top surface of the word line WL. The capping pattern 220 may cover top surfaces of the protection pattern 110 and the second insulating pattern 130. The capping pattern 220 may be extended in the second direction D2. In an example embodiment, the capping pattern 220 may be formed of or include at least one of silicon oxide, silicon nitride, or silicon oxynitride.

Landing pads LP may be respectively provided on the first and second vertical portions V1 and V2 of the semiconductor pattern SP. The landing pads LP may be in direct contact with the first and second vertical portions V1 and V2 and may be electrically connected to the first and second vertical portions V1 and V2. When viewed in a plan view, the landing pads LP may be spaced apart from each other in the first and second directions D1 and D2 and may be arranged in various shapes (e.g., matrix, zigzag, and honeycomb shapes). When viewed in a plan view, each of the landing pads LP may have various shapes (e.g., circular, elliptical, rectangular, square, diamond, and hexagonal shapes).

In an example embodiment, the landing pads LP may be formed of at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or combinations thereof, but the inventive concepts are not limited to this example.

A third interlayer insulating layer 240 may be provided on the first and second insulating patterns 120 and 130 to fill a space between the landing pads LP. The third interlayer insulating layer 240 may be formed of or include at least one of silicon oxide, silicon nitride, or silicon oxynitride and may have a single- or multi-layered structure.

The data storage patterns DSP may be provided on the landing pads LP, respectively. The data storage patterns DSP may be electrically and respectively connected to the first and second vertical portions V1 and V2 of the semiconductor pattern SP through the landing pads LP.

In an example embodiment, the data storage patterns DSP may be a capacitor and may include bottom and top electrodes and a capacitor dielectric layer interposed therebetween. In this case, the lower electrode may be in contact with the landing pad LP and may have various shapes (e.g., circular, elliptical, rectangular, square, diamond, and hexagonal shapes), when viewed in a plan view.

Alternatively, the data storage pattern DSP may be a variable resistance pattern whose resistance can be switched to one of at least two states by an electric pulse applied thereto. For example, the data storage patterns DSP may be formed of or include at least one of phase-change materials whose crystal state can be changed depending on an amount of a current applied thereto, perovskite compounds, transition metal oxides, magnetic materials, ferromagnetic materials, or antiferromagnetic materials.

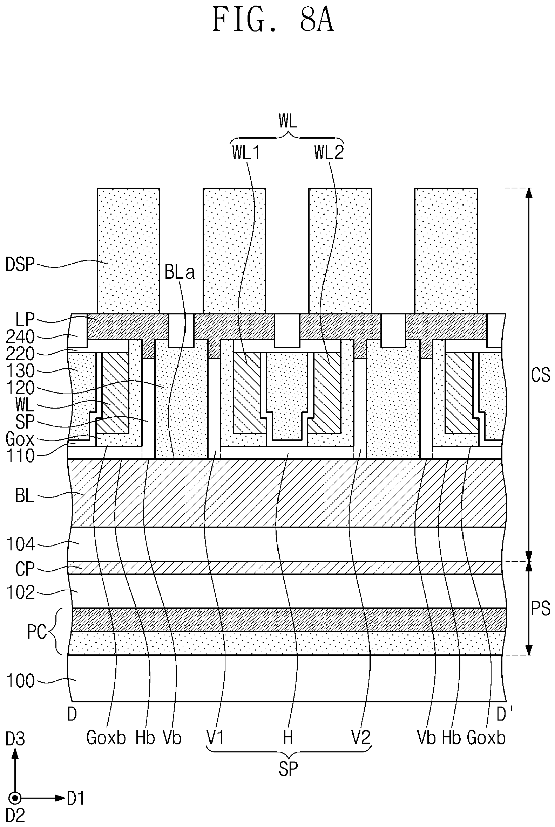

FIGS. 8A to 8D are sectional views, each of which is taken along the line D-D' of FIG. 3. For concise description, a previously described element may be identified by the same reference number without repeating an overlapping description thereof.

Referring to FIGS. 8A to 8D, the top surface of the bit line BL may be straightly extended in the first direction D1. The top surface of the bit line BL may be maintained to substantially the same height, even when a position in the first direction D1 is changed. Accordingly, the top surface of the bit line BL may be the uppermost surface BLa of the bit line BL.

The horizontal portion H of the semiconductor pattern SP may be provided on the top surface of the bit line BL. The bottom surface Hb of the horizontal portion H may be in contact with the uppermost surface BLa of the bit line BL and may be located at substantially the same height as the uppermost surface BLa of the bit line BL.

As an example, the first insulating pattern 120 may be in contact with the uppermost surface BLa of the bit line BL, as shown in FIG. 8A. The first insulating pattern 120 may cover the outer side surfaces of the first and second vertical portions V1 and V2 of the semiconductor pattern SP. The bottom surface Hb of the horizontal portion H may be located at substantially the same height as the lowermost surface of the first insulating pattern 120.

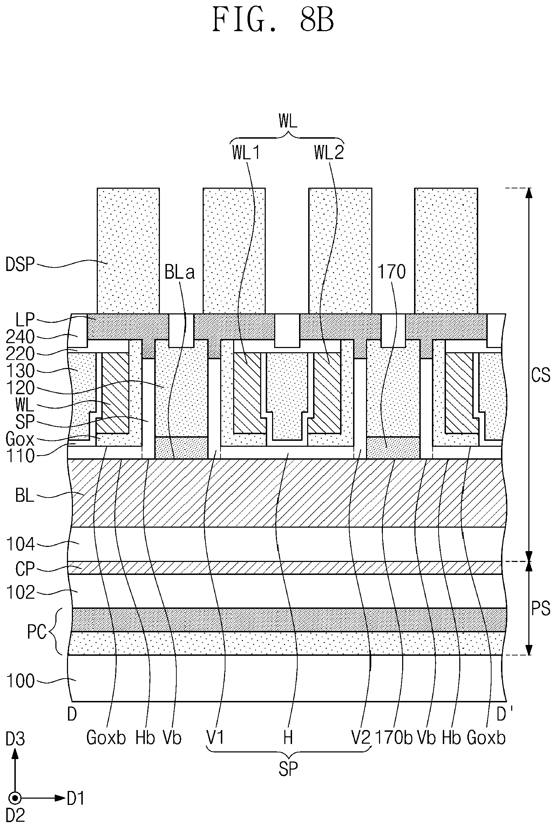

As another example, the blocking pattern 170 may be interposed between the first insulating pattern 120 and the bit line BL and between the semiconductor patterns SP, which are adjacent to each other in the first direction D1, as shown in FIG. 8B. The bottom surface Hb of the horizontal portion H may be located at substantially the same height as the lowermost surface 170b of the blocking pattern 170.

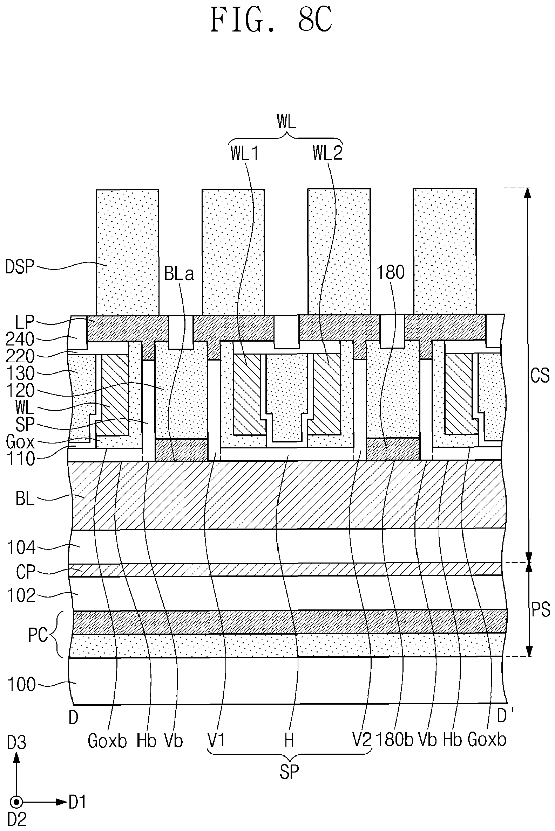

As still another example, the lower pattern 180 may be interposed between the first insulating pattern 120 and the bit line BL and between the semiconductor patterns SP, which are adjacent to each other in the first direction D1, as shown in FIG. 8C. The bottom surface Hb of the horizontal portion H may be located at substantially the same height as the lowermost surface 180b of the lower pattern 180.

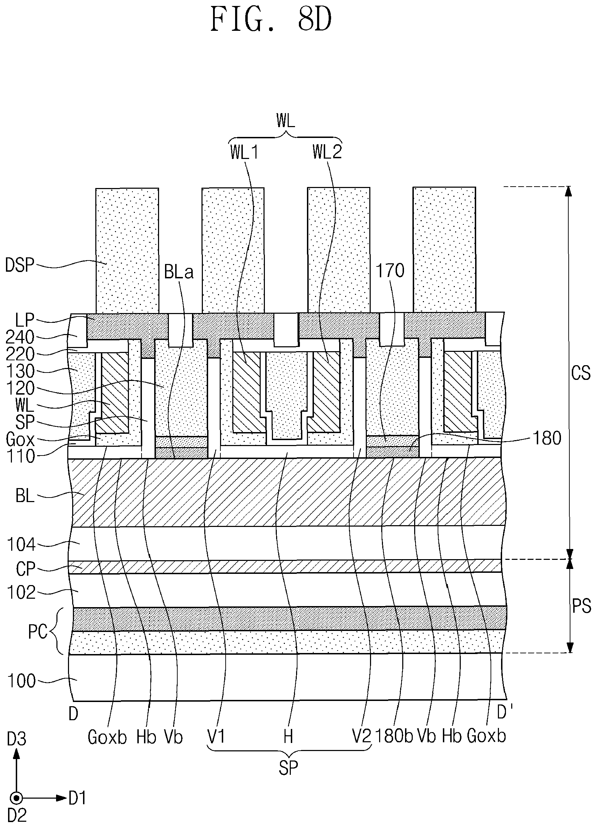

As yet another example, the blocking and lower patterns 170 and 180 may be interposed between the first insulating pattern 120 and the bit line BL and between the semiconductor patterns SP, which are adjacent to each other in the first direction D1, as shown in FIG. 8D. As an example, the lower pattern 180 may be located at a level lower than the blocking pattern 170 and may be interposed between the bit line BL and the blocking pattern 170. In this case, the bottom surface Hb of the horizontal portion H may be located at substantially the same height as the lowermost surface 180b of the lower pattern 180. However, the inventive concepts are not limited to this example, and although not shown, the stacking shape of the blocking and lower patterns 170 and 180 may be variously changed.

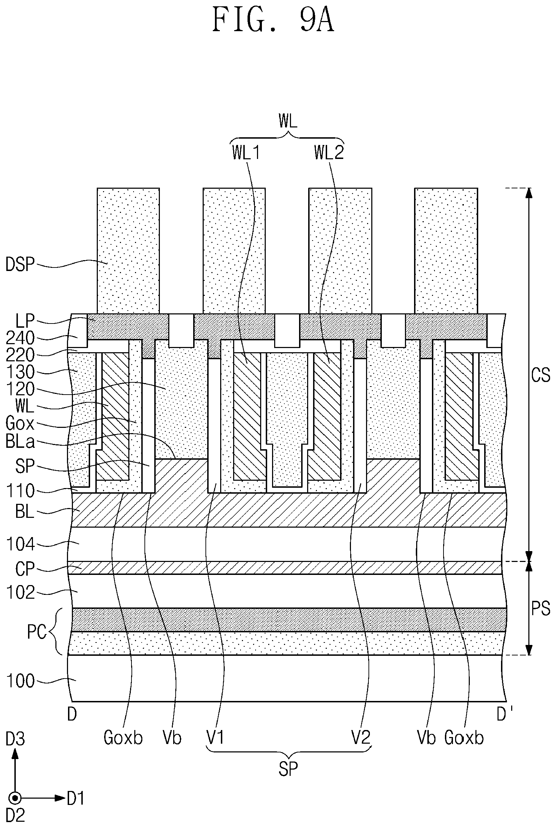

FIGS. 9A to 9D are sectional views, each of which is taken along the line D-D' of FIG. 3. For concise description, a previously described element may be identified by the same reference number without repeating an overlapping description thereof.

Referring to FIGS. 9A to 9D, the semiconductor pattern SP may include the first vertical portion V1 and the second vertical portion V2, which are opposite to each other and spaced apart from each other. The word line WL may be disposed on each of the first and second vertical portions V1 and V2. The word line WL may include the first word line WL1, which is provided on the inner side surface of the first vertical portion V1, and the second word line WL2, which is provided on the inner side surface of the second vertical portion V2. The gate insulating pattern Gox may be interposed between the first vertical portion V1 and the first word line WL1 and between the second vertical portion V2 and the second word line WL2. The second insulating pattern 130 may be provided to fill a space between the first and second word lines WL1 and WL2. The bottom surfaces Vb of the first and second vertical portions V1 and V2 may be located at substantially the same height as a bottom surface Goxb of the gate insulating pattern Gox. As an example, the bottom surface Goxb of the gate insulating pattern Gox may be the lowermost portion of the bottom surface of the gate insulating pattern Gox, but the inventive concepts are not limited to this example.

The bit line BL may have an uneven top surface. The top surface of the bit line BL may be recessed below a region from the outer side surface of the first vertical portion V1 to the outer side surface of the second vertical portion V2. The bit line BL may have the uppermost surface BLa in a region between the semiconductor patterns SP, which are adjacent to each other in the first direction D1.

Lower portions of the first and second vertical portions V1 and V2 and lower portions of the gate insulating pattern Gox may be buried or received in an upper portion of the bit line BL. The bottom surfaces Vb of the first and second vertical portions V1 and V2 and the bottom surface Goxb of the gate insulating pattern Gox may be located at a height lower than the uppermost surface BLa of the bit line BL. The lower portions of the first and second vertical portions V1 and V2 may be in contact with the bit line BL. As an example, a portion of the word line WL may be buried or received in the upper portion of the bit line BL. The buried portion of the word line WL may be horizontally overlapped with the bit line BL. Bottom surfaces of the first and second word lines WL1 and WL2 may be positioned at a height lower than the uppermost surface BLa of the bit line BL.

As an example, the first insulating pattern 120 may be in contact with the uppermost surface BLa of the bit line BL, as shown in FIG. 9A. The first insulating pattern 120 may cover the outer side surfaces of the first and second vertical portions V1 and V2 of the semiconductor pattern SP. The bottom surfaces Vb of the first and second vertical portions V1 and V2 and the bottom surface Goxb of the gate insulating pattern Gox may be located at a height lower than the lowermost surface of the first insulating pattern 120.

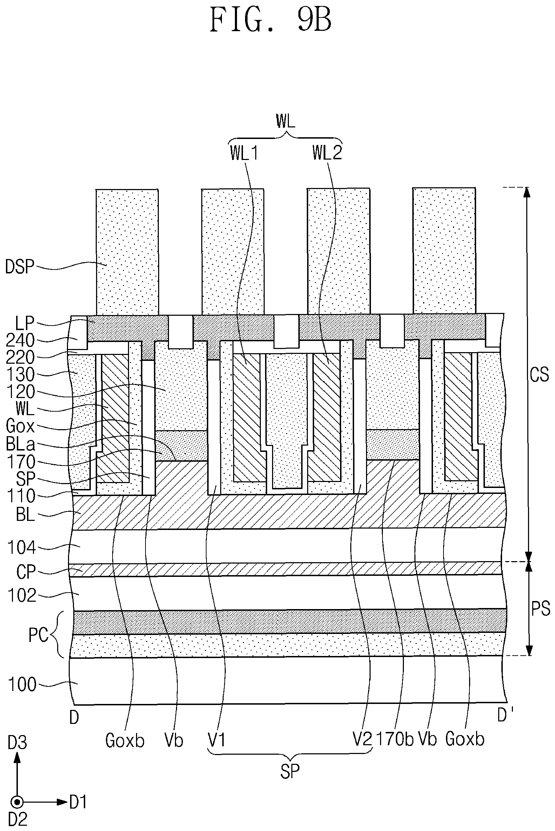

As another example, the blocking pattern 170 may be interposed between the first insulating pattern 120 and the bit line BL and between the semiconductor patterns SP, which are adjacent to each other in the first direction D1, as shown in FIG. 9B. The bottom surfaces Vb of the first and second vertical portions V1 and V2 and the bottom surface Goxb of the gate insulating pattern Gox may be located at a height lower than the lowermost surface 170b of the blocking pattern 170.

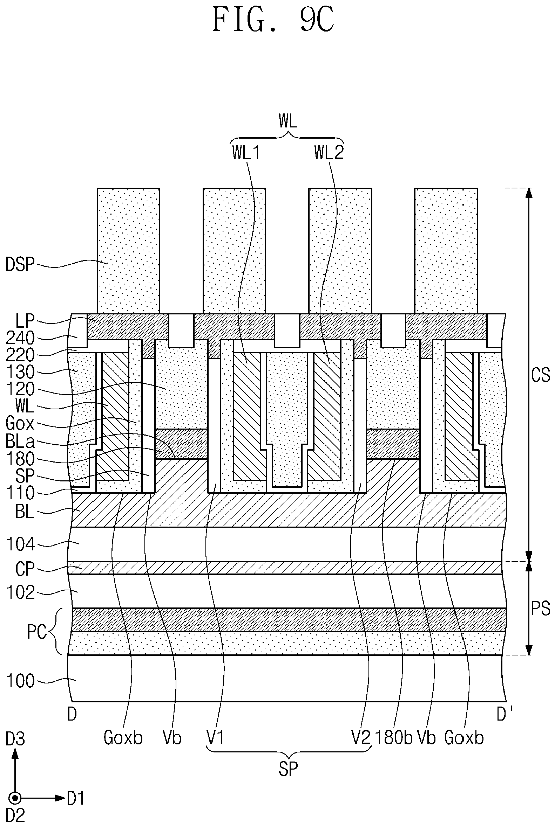

As still other example, the lower pattern 180 may be interposed between the first insulating pattern 120 and the bit line BL and between the semiconductor patterns SP, which are adjacent to each other in the first direction D1, as shown in FIG. 9C. The bottom surfaces Vb of the first and second vertical portions V1 and V2 and the bottom surface Goxb of the gate insulating pattern Gox may be located at a height lower than the lowermost surface 180b of the lower pattern 180.

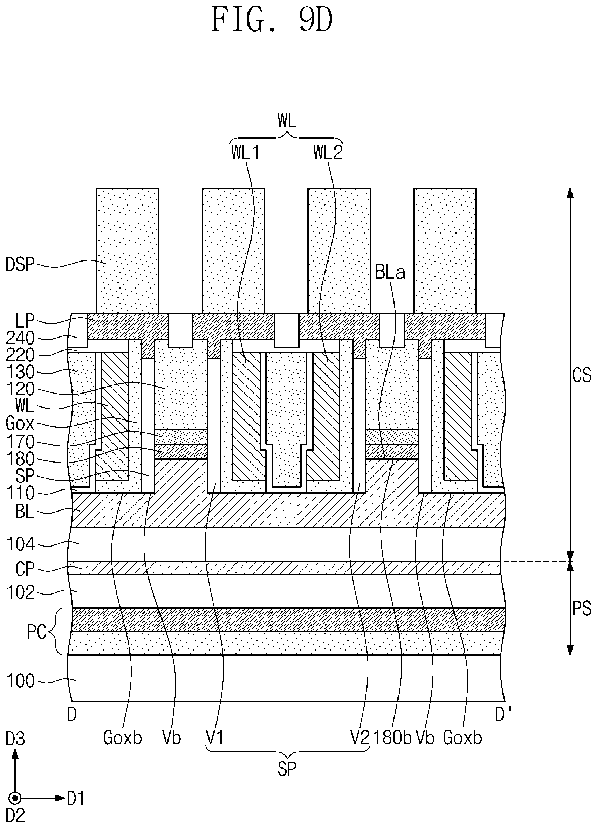

As yet another example, the blocking and lower patterns 170 and 180 may be interposed between the first insulating pattern 120 and the bit line BL and between the semiconductor patterns SP, which are adjacent to each other in the first direction D1, as shown in FIG. 9D. As an example, the lower pattern 180 may be located at a level lower than the blocking pattern 170 and may be interposed between the bit line BL and the blocking pattern 170. In this case, the bottom surfaces Vb of the first and second vertical portions V1 and V2 and the bottom surface Goxb of the gate insulating pattern Gox may be located at a height lower than the lowermost surface 180b of the lower pattern 180. However, the inventive concepts are not limited to this example, and in an example embodiment, although not shown, the stacking shape of the blocking and lower patterns 170 and 180 may be variously changed.

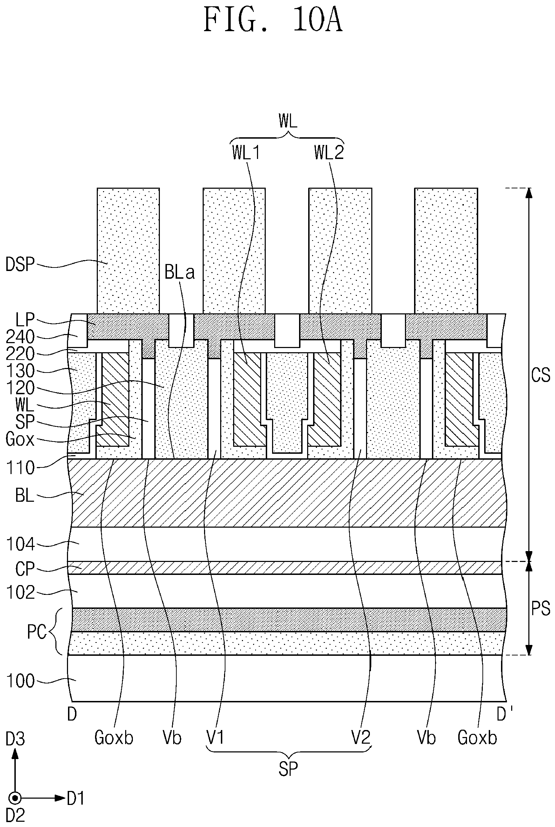

FIGS. 10A to 10D are sectional views, each of which is taken along the line D-D' of FIG. 3. For concise description, a previously described element may be identified by the same reference number without repeating an overlapping description thereof.

Referring to FIGS. 10A to 10D, the top surface of the bit line BL may be straightly extended in the first direction D1. The top surface of the bit line BL may be maintained to substantially the same height, even when a position in the first direction D1 is changed. Accordingly, the top surface of the bit line BL may be the uppermost surface BLa of the bit line BL.

The first and second vertical portions V1 and V2 of the semiconductor pattern SP may be provided on the top surface of the bit line BL. The bottom surfaces Vb of the first and second vertical portions V1 and V2 and the bottom surface Goxb of the gate insulating pattern Gox may be in contact with the uppermost surface BLa of the bit line BL and may be located at substantially the same height as the uppermost surface BLa of the bit line BL.

As an example, the first insulating pattern 120 may be in contact with the uppermost surface BLa of the bit line BL, as shown in FIG. 10A. The first insulating pattern 120 may cover the outer side surfaces of the first and second vertical portions V1 and V2 of the semiconductor pattern SP. The bottom surfaces Vb of the first and second vertical portions V1 and V2 and the bottom surface Goxb of the gate insulating pattern Gox may be located at substantially the same height as the lowermost surface of the first insulating pattern 120.

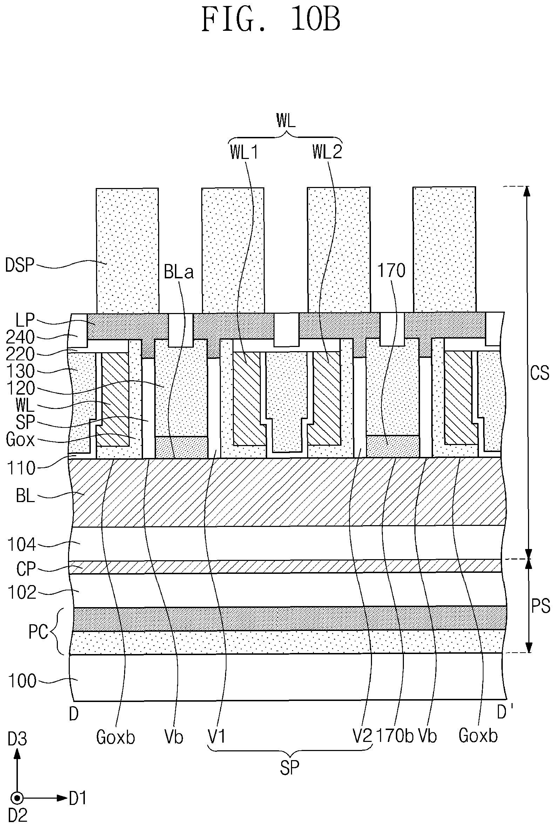

As another example, the blocking pattern 170 may be interposed between the first insulating pattern 120 and the bit line BL and between the semiconductor patterns SP, which are adjacent to each other in the first direction D1, as shown in FIG. 10B. The bottom surfaces Vb of the first and second vertical portions V1 and V2 and the bottom surface Goxb of the gate insulating pattern Gox may be located at substantially the same height as the lowermost surface 170b of the blocking pattern 170.

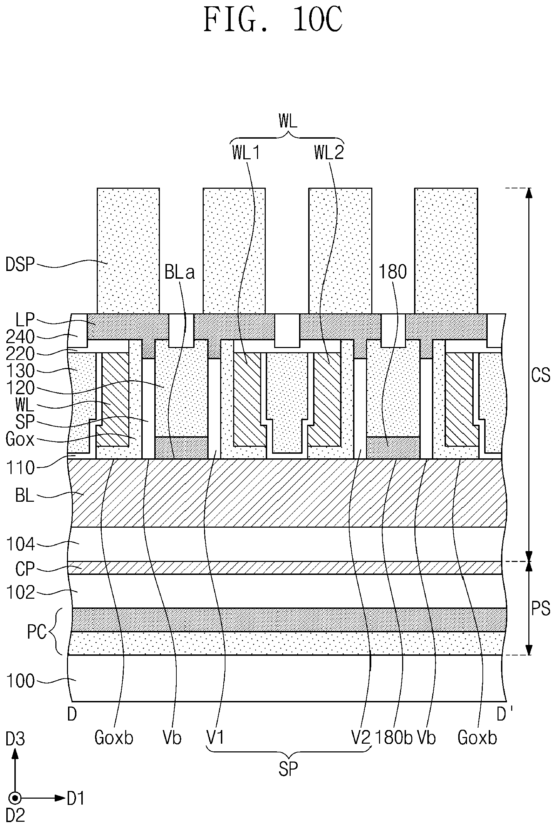

As still other example, the lower pattern 180 may be interposed between the first insulating pattern 120 and the bit line BL and between the semiconductor patterns SP, which are adjacent to each other in the first direction D1, as shown in FIG. 10C. The bottom surfaces Vb of the first and second vertical portions V1 and V2 and the bottom surface Goxb of the gate insulating pattern Gox may be located at substantially the same height as the lowermost surface 180b of the lower pattern 180.

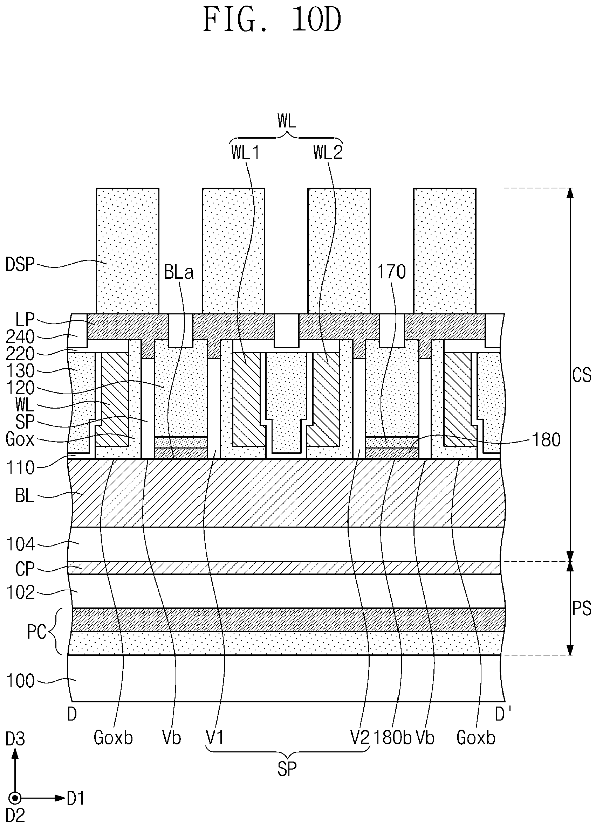

As yet other example, the blocking and lower patterns 170 and 180 may be interposed between the first insulating pattern 120 and the bit line BL and between the semiconductor patterns SP, which are adjacent to each other in the first direction D1, as shown in FIG. 10D. As an example, the lower pattern 180 may be located at a level lower than the blocking pattern 170 and may be interposed between the bit line BL and the blocking pattern 170. In this case, the bottom surfaces Vb of the first and second vertical portions V1 and V2 and the bottom surface Goxb of the gate insulating pattern Gox may be located at substantially the same height as the lowermost surface 180b of the lower pattern 180. However, the inventive concepts are not limited to this example, and although not shown, the stacking shape of the blocking and lower patterns 170 and 180 may be variously changed.

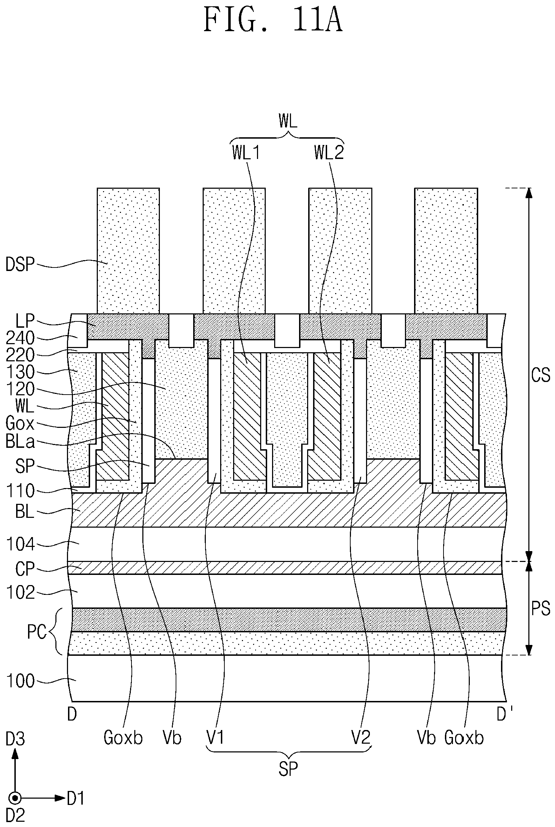

FIGS. 11A to 11D are sectional views, each of which is taken along the line D-D' of FIG. 3. For concise description, a previously described element may be identified by the same reference number without repeating an overlapping description thereof.

Referring to FIGS. 11A to 11D, the semiconductor pattern SP may include the first vertical portion V1 and the second vertical portion V2, which are opposite to each other and spaced apart from each other. The word line WL may be disposed on each of the first and second vertical portions V1 and V2. The word line WL may include the first word line WL1, which is provided on the inner side surface of the first vertical portion V1, and the second word line WL2, which is provided on the inner side surface of the second vertical portion V2. The gate insulating pattern Gox may be interposed between the first vertical portion V1 and the first word line WL1 and between the second vertical portion V2 and the second word line WL2. The second insulating pattern 130 may be provided to fill a space between the first and second word lines WL1 and WL2.

The bit line BL may have an uneven top surface. The top surface of the bit line BL may be recessed below a region from the outer side surface of the first vertical portion V1 to the outer side surface of the second vertical portion V2. The bit line BL may have the uppermost surface BLa in a region between the semiconductor patterns SP, which are adjacent to each other in the first direction D1.

Lower portions of the first and second vertical portions V1 and V2 and lower portions of the gate insulating pattern Gox may be buried or received in an upper portion of the bit line BL. The bottom surfaces Vb of the first and second vertical portions V1 and V2 and the bottom surface Goxb of the gate insulating pattern Gox may be located at a height lower than the uppermost surface BLa of the bit line BL. The bottom surfaces Vb of the first and second vertical portions V1 and V2 may be located at a height higher than the bottom surface Goxb of the gate insulating pattern Gox. The lower portions of the first and second vertical portions V1 and V2 may be in contact with the bit line BL. As an example, a portion of the word line WL may be buried or received in the upper portion of the bit line BL. The buried portion of the word line WL may be horizontally overlapped with the bit line BL. Bottom surfaces of the first and second word lines WL1 and WL2 may be located at a height lower than the uppermost surface BLa of the bit line BL.

As an example, the first insulating pattern 120 may be in contact with the uppermost surface BLa of the bit line BL, as shown in FIG. 11A. The first insulating pattern 120 may cover the outer side surfaces of the first and second vertical portions V1 and V2 of the semiconductor pattern SP. The bottom surfaces Vb of the first and second vertical portions V1 and V2 and the bottom surface Goxb of the gate insulating pattern Gox may be located at a height lower than the lowermost surface of the first insulating pattern 120.

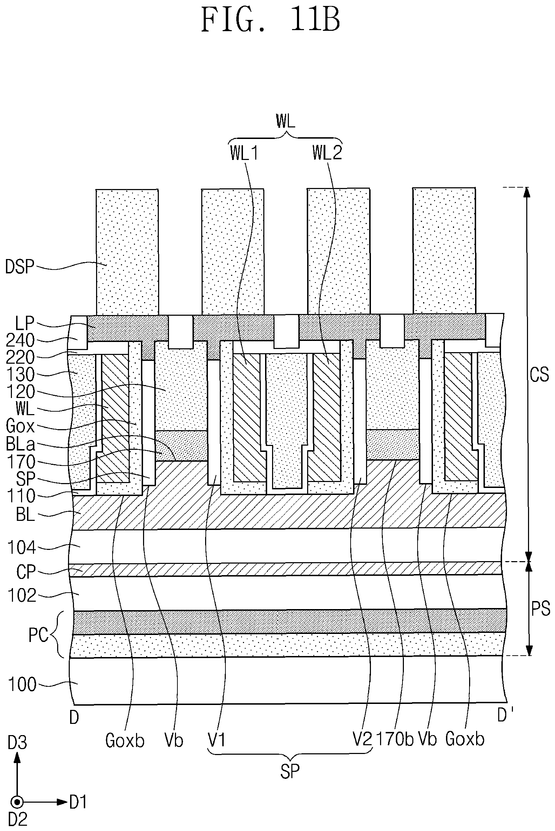

As another example, the blocking pattern 170 may be interposed between the first insulating pattern 120 and the bit line BL and between the semiconductor patterns SP, which are adjacent to each other in the first direction D1, as shown in FIG. 11B. The bottom surfaces Vb of the first and second vertical portions V1 and V2 and the bottom surface Goxb of the gate insulating pattern Gox may be located at a height lower than the lowermost surface 170b of the blocking pattern 170.

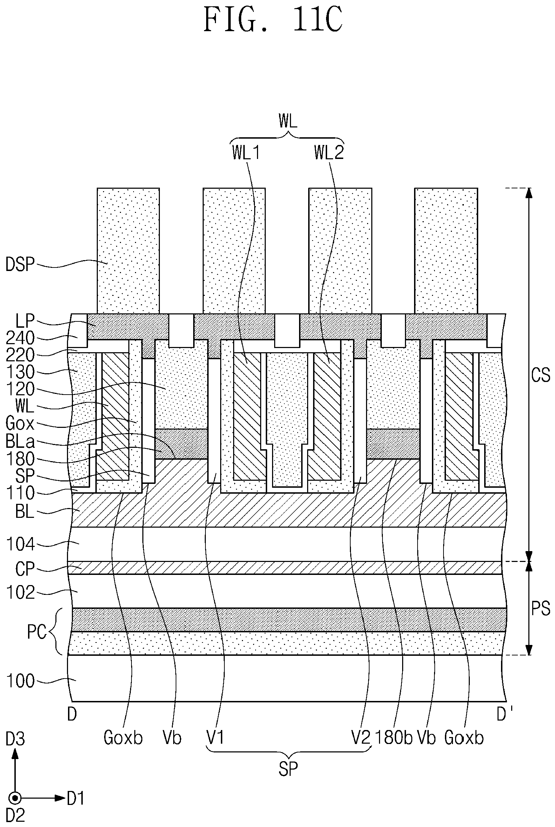

As still another example, the lower pattern 180 may be interposed between the first insulating pattern 120 and the bit line BL and between the semiconductor patterns SP, which are adjacent to each other in the first direction D1, as shown in FIG. 11C. The bottom surfaces Vb of the first and second vertical portions V1 and V2 and the bottom surface Goxb of the gate insulating pattern Gox may be located at a height lower than the lowermost surface 180b of the lower pattern 180.

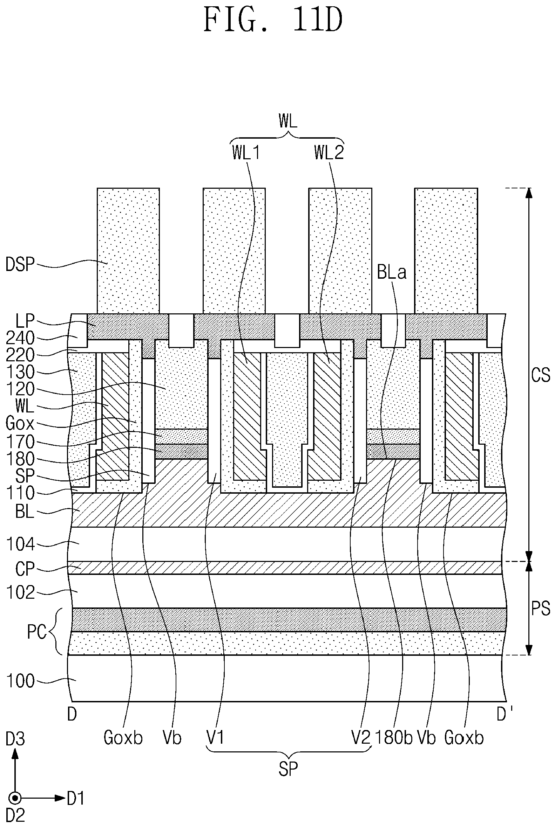

As yet another example, the blocking and lower patterns 170 and 180 may be interposed between the first insulating pattern 120 and the bit line BL and between the semiconductor patterns SP, which are adjacent to each other in the first direction D1, as shown in FIG. 11D. As an example, the lower pattern 180 may be located at a level lower than the blocking pattern 170 and may be interposed between the bit line BL and the blocking pattern 170. In this case, the bottom surfaces Vb of the first and second vertical portions V1 and V2 and the bottom surface Goxb of the gate insulating pattern Gox may be located at a height lower than the lowermost surface 180b of the lower pattern 180. However, the inventive concepts are not limited to this example, and although not shown, the stacking shape of the blocking and lower patterns 170 and 180 may be variously changed.

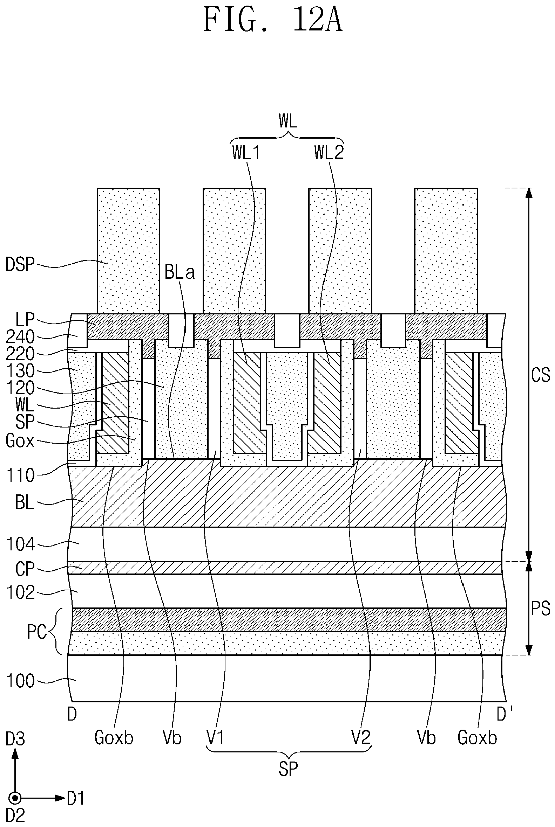

FIGS. 12A to 12D are sectional views, each of which is taken along the line D-D' of FIG. 3. For concise description, a previously described element may be identified by the same reference number without repeating an overlapping description thereof.

Referring to FIGS. 12A to 12D, the bit line BL may have an uneven top surface. The top surface of the bit line BL may be recessed below a region from the inner side surface of the first vertical portion V1 to the inner side surface of the second vertical portion V2. The bit line BL may have the uppermost surface BLa below a region between the semiconductor patterns SP, which are adjacent to each other in the first direction D1, and below the first and second vertical portions V1 and V2.

The first and second vertical portions V1 and V2 may be provided on the uppermost surface BLa of the bit line BL. The bottom surfaces Vb of the first and second vertical portions V1 and V2 may be in contact with the uppermost surface BLa of the bit line BL and may be located at substantially the same height as the uppermost surface BLa of the bit line BL.

Lower portions of the gate insulating pattern Gox may be buried or received in an upper portion of the bit line BL. The bottom surface Goxb of the gate insulating pattern Gox may be located at a height lower than the uppermost surface BLa of the bit line BL (i.e., a height lower than the bottom surfaces Vb of the first and second vertical portions V1 and V2).

As an example, a bottom surface of the word line WL may be located at a height higher than the uppermost surface BLa of the bit line BL, as shown in FIGS. 12A to 12D. However, the inventive concepts are not limited to this example. As another example, although not shown, the bottom surface of the word line WL may be located at a height that is lower than or equal to the uppermost surface BLa of the bit line BL.

As an example, the first insulating pattern 120 may be in contact with the uppermost surface BLa of the bit line BL, as shown in FIG. 12A. The first insulating pattern 120 may cover the outer side surfaces of the first and second vertical portions V1 and V2 of the semiconductor pattern SP. The bottom surfaces Vb of the first and second vertical portions V1 and V2 may be located at substantially the same height as the lowermost surface of the first insulating pattern 120. The bottom surface Goxb of the gate insulating pattern Gox may be located at a height lower than the lowermost surface of the first insulating pattern 120.

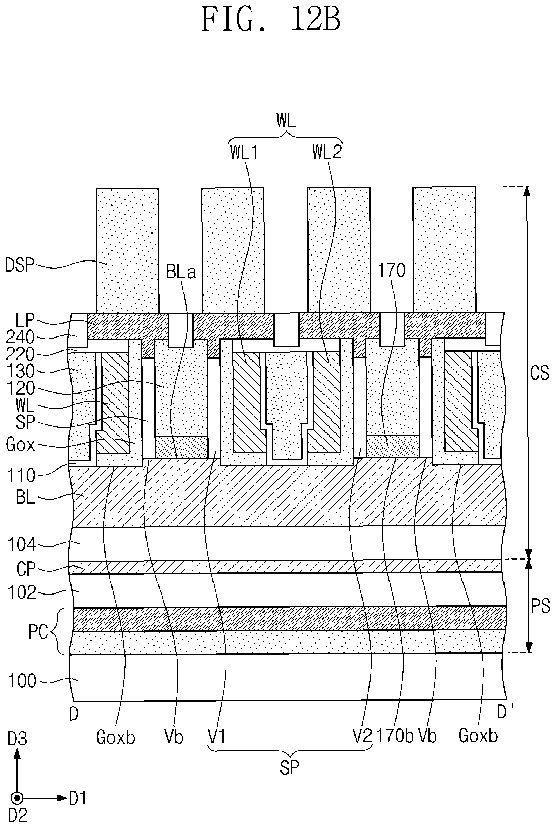

As another example, the blocking pattern 170 may be interposed between the first insulating pattern 120 and the bit line BL and between the semiconductor patterns SP, which are adjacent to each other in the first direction D1, as shown in FIG. 12B. The bottom surfaces Vb of the first and second vertical portions V1 and V2 may be located at substantially the same height as the lowermost surface 170b of the blocking pattern 170. The bottom surface Goxb of the gate insulating pattern Gox may be located at a height lower than the lowermost surface 170b of the blocking pattern 170.

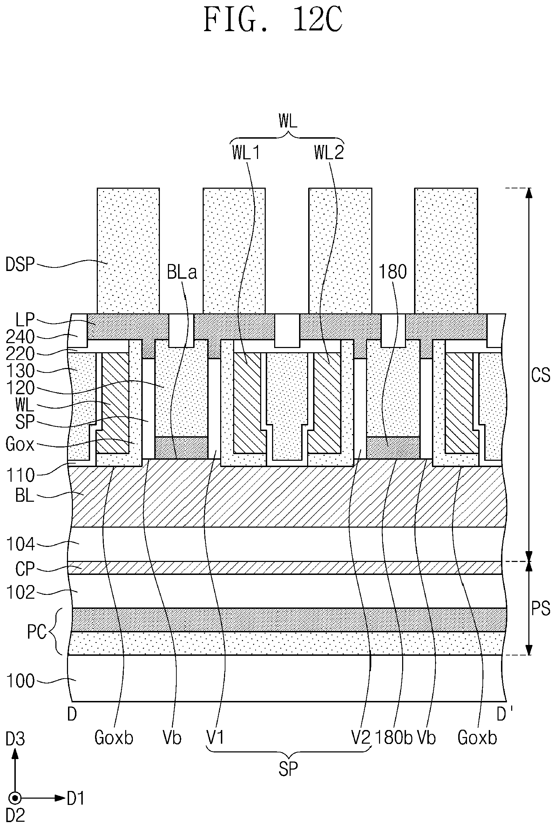

As still another example, the lower pattern 180 may be interposed between the first insulating pattern 120 and the bit line BL and between the semiconductor patterns SP, which are adjacent to each other in the first direction D1, as shown in FIG. 12C. The bottom surfaces Vb of the first and second vertical portions V1 and V2 may be located at substantially the same height as the lowermost surface 180b of the lower pattern 180. The bottom surface Goxb of the gate insulating pattern Gox may be located at a height lower than the lowermost surface 180b of the lower pattern 180.

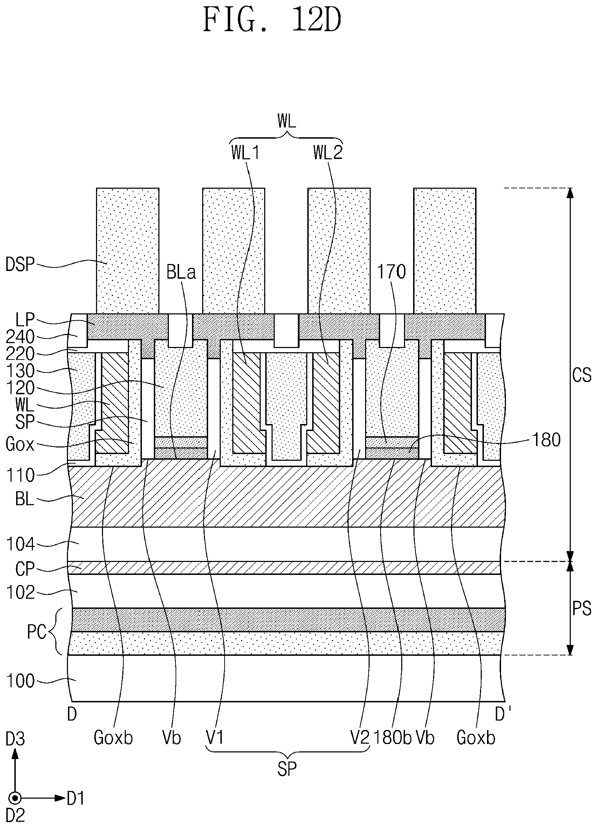

As yet another example, the blocking and lower patterns 170 and 180 may be interposed between the first insulating pattern 120 and the bit line BL and between the semiconductor patterns SP, which are adjacent to each other in the first direction D1, as shown in FIG. 12D. As an example, the lower pattern 180 may be located at a level lower than the blocking pattern 170 and may be interposed between the bit line BL and the blocking pattern 170. In this case, the bottom surfaces Vb of the first and second vertical portions V1 and V2 may be located at substantially the same height as the lowermost surface 180b of the lower pattern 180. The bottom surface Goxb of the gate insulating pattern Gox may be located at a height lower than the lowermost surface 180b of the lower pattern 180. However, the inventive concepts are not limited to this example, and although not shown, the stacking shape of the blocking and lower patterns 170 and 180 may be variously changed.

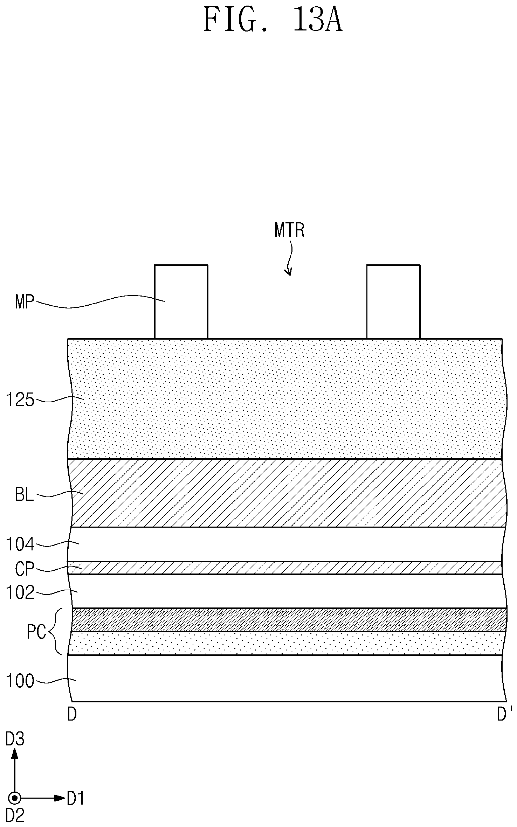

FIGS. 13A to 13E are sectional views illustrating a method of fabricating the semiconductor device of FIG. 7A. Hereinafter, a method of fabricating the semiconductor device of FIG. 7A will be described in more detail with reference to FIGS. 3 and 13A to 13E. For concise description, a previously described element may be identified by the same reference number without repeating an overlapping description thereof.

Referring to FIGS. 3 and 13A, the bit line BL may be formed on the substrate 100. In an example embodiment, a plurality of the bit lines BL may be formed. The bit lines BL may be extended in the first direction D1 and may be spaced apart from each other in the second direction D2. The bit line BL may be formed to be electrically connected to interconnection lines thereunder. The formation of the bit line BL may include depositing a bit line layer (not shown) on the substrate 100 and patterning the bit line layer to form the bit line BL.

A first insulating layer 125 and mask patterns MP may be sequentially formed on the bit line BL. The first insulating layer 125 may cover the entire top surface of the substrate 100. In an example embodiment, the first insulating layer 125 may be formed of or include at least one of silicon oxide, silicon nitride, silicon oxynitride, or low-k dielectric materials.

The mask patterns MP may include line patterns, which are extended in the second direction D2 and are spaced apart from each other in the first direction D1. The mask patterns MP may have a mask trench MTR, and in an example embodiment, a plurality of the mask trenches MTR may be provided. The mask trenches MTR may be spaced apart from each other in the first direction D1 and may be extended in the second direction D2. The formation of the mask patterns MP may include forming a mask layer (not shown) on the first insulating layer 125 and patterning the mask layer to form the mask patterns MP.

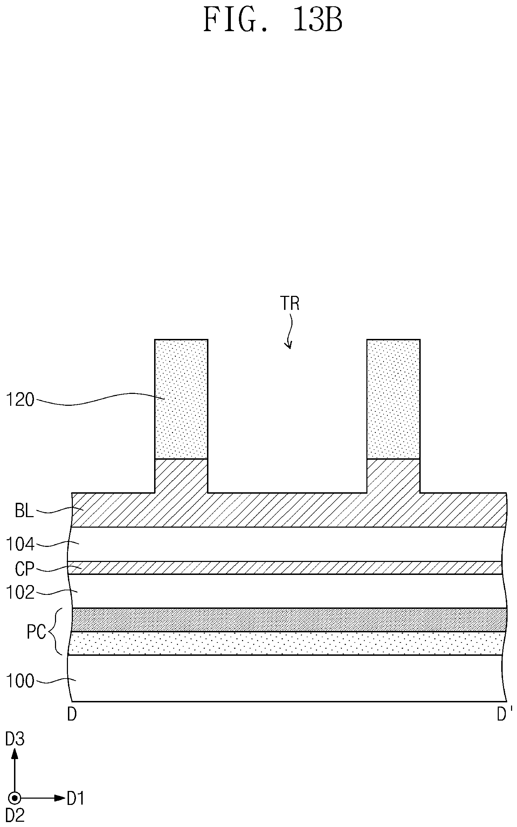

Referring to FIGS. 3 and 13B, the first insulating pattern 120 may be formed on the bit line BL. In an example embodiment, a plurality of the first insulating patterns 120 may be provided. The formation of the first insulating pattern 120 may include etching the first insulating layer 125 using the mask patterns MP of FIG. 13A as an etch mask. Accordingly, the first insulating pattern 120 may be vertically overlapped with the mask patterns MP of FIG. 13A. The first insulating pattern 120 may be extended in the second direction D2. The etching process may be performed to partially recess an upper portion of the bit line BL. Accordingly, the top surface of the bit line BL may have an uneven shape.

The first insulating pattern 120 and the bit line BL may be formed to define a trench region TR, which is vertically overlapped with the mask trench MTR of FIG. 13A. In an example embodiment, a plurality of the trench regions TR may be provided and may be extended in the second direction D2. Side surfaces of the first insulating pattern 120 and a portion of the bit line BL may be exposed to the outside through the trench region TR.

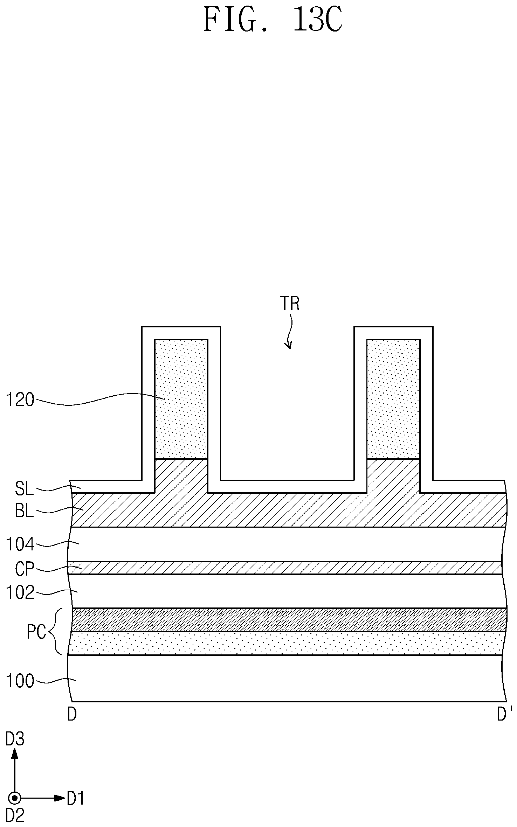

Referring to FIGS. 3 and 13C, a semiconductor layer SL may be formed to cover the entire top surface of the substrate 100. The formation of the semiconductor layer SL may include depositing the semiconductor layer SL using at least one of physical vapor deposition (PVD), thermal chemical vapor deposition (thermal CVD), low-pressure chemical vapor deposition (LP-CVD), plasma-enhanced chemical vapor deposition (PE-CVD), and atomic layer deposition (ALD) techniques. The semiconductor layer SL may conformally cover the exposed side surfaces of the first insulating pattern 120 and the portion of the bit line BL, which is exposed by the trench region TR. The semiconductor layer SL may be formed to partially fill the trench region TR.

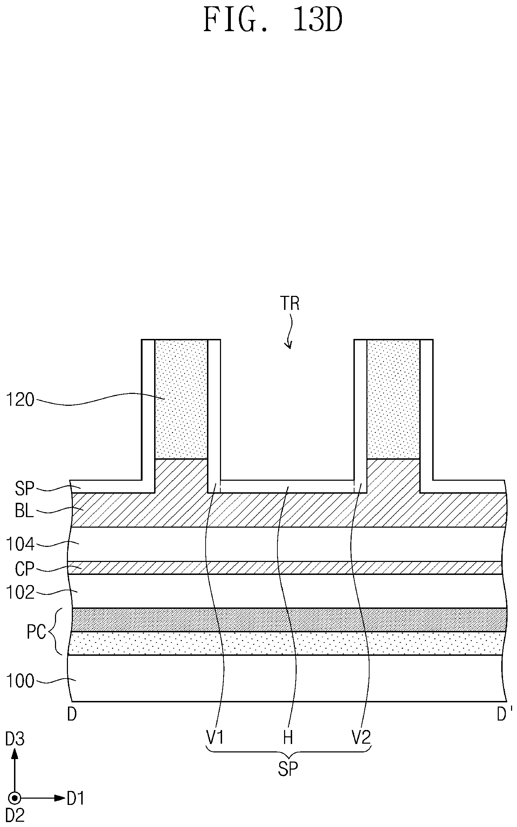

Referring to FIGS. 3 and 13D, the semiconductor layer SL may be partially removed. The partial removal of the semiconductor layer SL may include removing the semiconductor layer SL from regions, which are provided between adjacent ones of the bit lines in the second direction D2 and are extended in the first direction D 1, and removing the semiconductor layer SL from a top surface of the first insulating pattern 120. The semiconductor layer SL may be divided into a plurality of semiconductor patterns SP by the removal step. Each of the semiconductor patterns SP may include the first vertical portion V1 and the second vertical portion V2, which are opposite to each other, and the horizontal portion H connecting the first and second vertical portions V1 and V2. Lower portions of the first and second vertical portions V1 and V2 and at least a portion of the horizontal portion H may be buried or received in an upper portion of the bit line BL in the trench region TR.

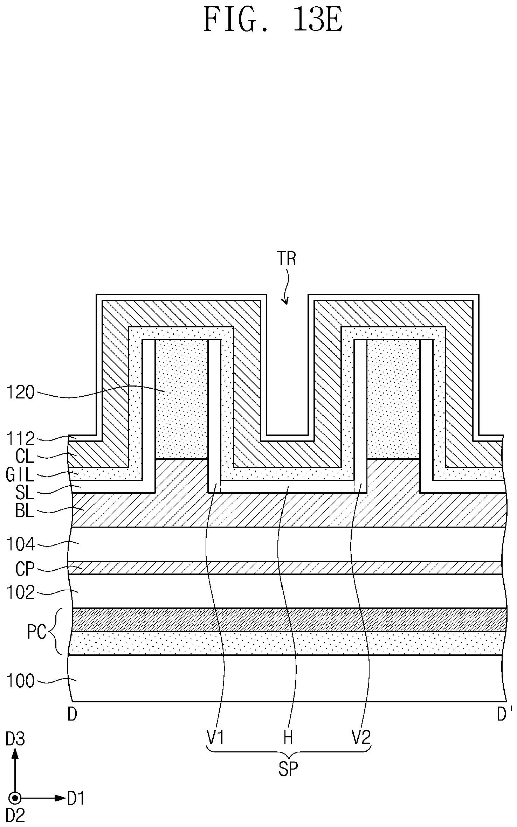

Referring to FIGS. 3 and 13E, a gate insulating layer GIL, a conductive layer CL, and a protection layer 112 may be formed to cover the entire top surface of the substrate 100. The gate insulating layer GIL, the conductive layer CL, and the protection layer 112 may conformally cover the inner side surfaces of the first and second vertical portions V1 and V2, the top surface of the horizontal portion H, and the top surface of the first insulating pattern 120 and may fill a portion of the trench region TR. The formation of the gate insulating layer GIL, the conductive layer CL, and the protection layer 112 may include sequentially depositing the gate insulating layer GIL, the conductive layer CL, and the protection layer 112 using at least one of physical vapor deposition (PVD), thermal chemical vapor deposition (thermal CVD), low-pressure chemical vapor deposition (LP-CVD), plasma-enhanced chemical vapor deposition (PE-CVD), and atomic layer deposition (ALD) techniques.

Referring back to FIGS. 3 and 7A, the word line WL and the gate insulating pattern Gox may be formed. The word line WL may be formed to include the first word line WL1 on the first vertical portion V1 and the second word line WL2 on the second vertical portion V2. In an example embodiment, the formation of the word line WL may include removing the conductive layer CL on the first insulating pattern 120 and on the horizontal portion H to form a plurality of the word lines WL that are separated from each other.

In an example embodiment, during the formation of the word line WL, the gate insulating layer GIL on the first insulating pattern 120 and on the horizontal portion H may be removed to form the gate insulating patterns Gox that are separated from each other. As another example, although not shown, during the formation of the word line WL, the gate insulating layer GIL on the first insulating pattern 120 may be removed to form the gate insulating patterns Gox separated from each other, and the gate insulating layer GIL on the horizontal portion H may not be removed and may be left as a part of the gate insulating pattern Gox. In this case, the gate insulating pattern Gox may have the shape of the connected letter U on the horizontal portion H.

As an example, although not shown, a portion of the horizontal portion H of the semiconductor pattern SP may be further removed during the formation of the word line WL and the gate insulating pattern Gox. In this case, the horizontal portion H may be divided into first and second sub-horizontal portions (not shown), which are respectively connected to the first and second vertical portions V1 and V2 and are spaced apart from each other. The first vertical portion V1 and the first sub-horizontal portion may be connected to have the shape of the letter L, and the second vertical portion V2 and the second sub-horizontal portion may be connected to have the shape of the letter L.

As an example, the word line WL may be formed such that the top surface thereof is located at a height lower than the top surface of the gate insulating pattern Gox and the top surface of the first insulating pattern 120.

A portion of the protection layer 112 may be removed by the removal process. After the removal process, an additional protection layer (not shown) may be formed on a remaining portion of the protection layer 112, and the remaining portion of the protection layer 112 and the additional protection layer may form the protection pattern 110.

Next, the second insulating pattern 130 may be formed between the first and second word lines WL1 and WL2. The second insulating pattern 130 may fill the trench region TR. The formation of the second insulating pattern 130 may include forming a second insulating layer (not shown) to fill the trench region TR and to cover the semiconductor pattern SP, the gate insulating pattern Gox, and the word line WL and removing an upper portion of the second insulating layer to form the second insulating patterns 130 that are separated from each other. The second insulating pattern 130 may be formed such that a top surface thereof is located at a height that is lower than the top surface of the gate insulating pattern Gox and the top surface of the first insulating pattern 120 and is adjacent to the top surface of the word line WL. Thus, a first recess region may be formed to expose the top surface of the second insulating pattern 130 and the top surface of the word line WL. The first recess region may be extended in the second direction D2.

The capping pattern 220 may be formed to fill the first recess region. The formation of the capping pattern 220 may include forming a capping layer (not shown) to fill the first recess region and to cover the top surface of the first insulating pattern 120 and removing an upper portion of the capping layer to form a plurality of capping patterns 220 that are separated from each other. When the capping pattern 220 is formed, the top surface of the first insulating pattern 120 and the top surfaces of the first and second vertical portions V1 and V2 may be exposed to the outside.

The landing pads LP may be formed on the first and second vertical portions V1 and V2 of the semiconductor pattern SP, respectively. The formation of the landing pads LP may include removing upper portions of the first and second vertical portions V1 and V2 to form a second recess region, forming a landing pad layer (not shown) to fill the second recess region and to cover the capping pattern 220, and removing portions of the landing pads to form a plurality of landing pads that are separated from each other.

The third interlayer insulating layer 240 may be formed on the first and second insulating patterns 120 and 130 to fill spaces between the landing pads LP. The data storage patterns DSP may be formed on the landing pads LP, respectively. The data storage patterns DSP may be electrically connected to the first and second vertical portions V1 and V2 of the semiconductor pattern SP, respectively, through the landing pads LP.

Although not shown, before the formation of the first insulating layer 125 of FIG. 13A, an auxiliary layer may be formed to cover the entire top surface of the substrate 100. An auxiliary pattern may be formed from the auxiliary layer through the etching process of FIG. 13B. The auxiliary pattern may include at least one of the blocking and lower patterns 170 and 180 described with reference to FIGS. 7B to 7D. Thereafter, the steps described with reference to FIGS. 13B to 13E may be performed to form the semiconductor device of FIGS. 7B to 7D.

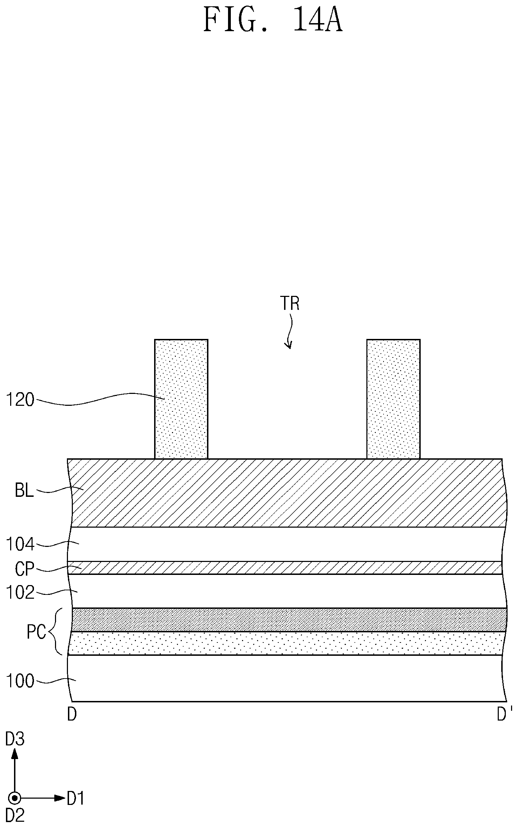

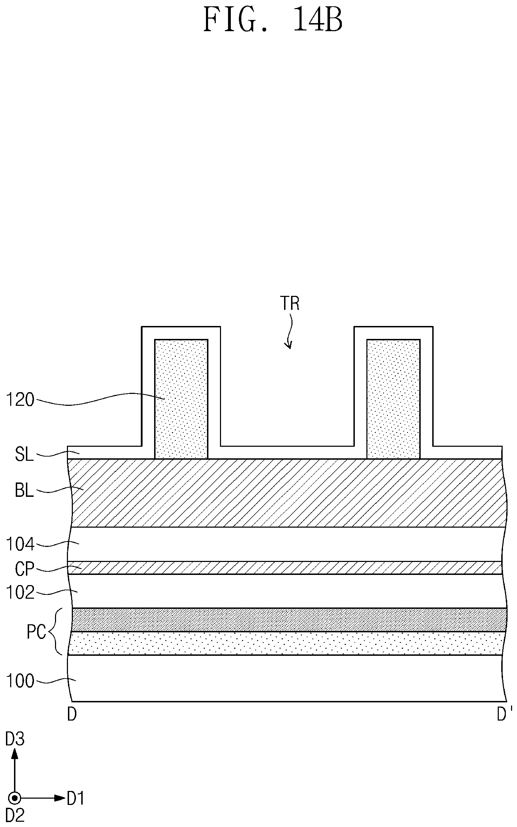

FIGS. 14A and 14B are sectional views illustrating a method of fabricating the semiconductor device of FIG. 8A. For concise description, a previously described element may be identified by the same reference number without repeating an overlapping description thereof.

Referring to FIGS. 3 and 14A, the first insulating pattern 120 may be formed on the bit line BL, after the step of FIG. 13A. Here, the bit line BL may not be etched. Accordingly, the top surface of the bit line BL (i.e., the uppermost surface of the bit line BL) may be straightly extended in the first direction D1. The trench region TR may be formed, and in this case, the side surfaces of the first insulating pattern 120 and the top surface of the bit line BL may be exposed to the outside through the trench region TR.

Referring to FIGS. 3 and 14B, the semiconductor layer SL may be formed to cover the entire top surface of the substrate 100. The semiconductor layer SL may conformally cover the exposed side surfaces of the first insulating pattern 120 and the exposed top surface of the bit line BL. The semiconductor layer SL may be formed to partially fill the trench region TR.

Thereafter, the steps described with reference to FIGS. 13C to 13E and 7A may be performed to form the semiconductor device of FIG. 8A.

Although not shown, before the formation of the first insulating layer 125 of FIG. 13A, an auxiliary layer may be formed to cover the entire top surface of the substrate 100, and as a result, the semiconductor device of FIGS. 8B to 8D may be formed.

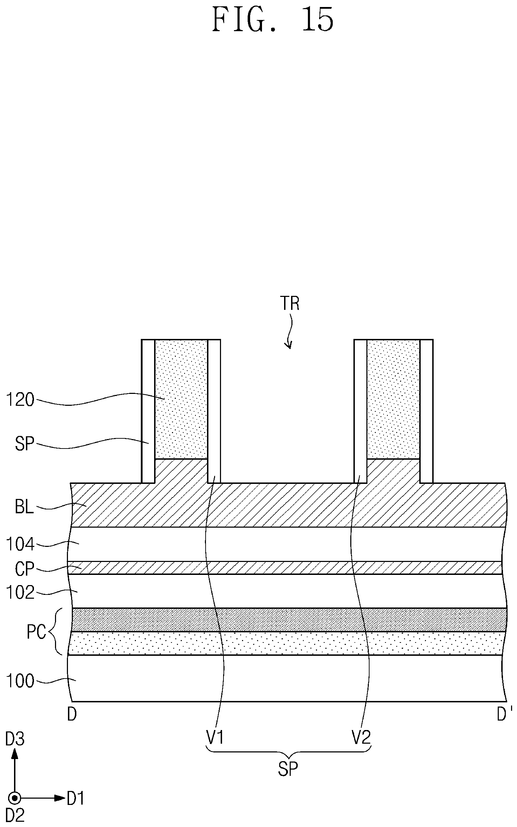

FIG. 15 is a sectional view illustrating a method of fabricating the semiconductor device of FIG. 9A. For concise description, a previously described element may be identified by the same reference number without repeating an overlapping description thereof.

Referring to FIGS. 3 and 15, portions of the semiconductor layer SL, which are located on the top surface of the first insulating pattern 120 and the top surface of the bit line BL in the trench region TR, may be removed after the step of FIG. 13C. The semiconductor layer SL may be divided into a plurality of semiconductor patterns SP by the removal step. Each of the semiconductor patterns SP may include the first and second vertical portions V1 and V2, which are opposite to each other and are spaced apart from each other. The semiconductor pattern SP may not include the horizontal portion H. As a result of the removal process, the top surface of the bit line BL in the trench region TR may be re-exposed to the outside.

Thereafter, the steps described with reference to FIGS. 13D, 13E, and 7A may be performed to form the semiconductor device of FIG. 9A.

Although not shown, in the case where the steps described with reference to FIGS. 14A and 14B are performed before the step described with reference to FIG. 15, the semiconductor device of FIG. 10A may be formed.

Although not shown, before the formation of the first insulating layer 125 of FIG. 13A, an auxiliary layer may be formed to cover the entire top surface of the substrate 100, and as a result, the semiconductor device of FIGS. 9B to 9D and 10B to 10D may be formed.

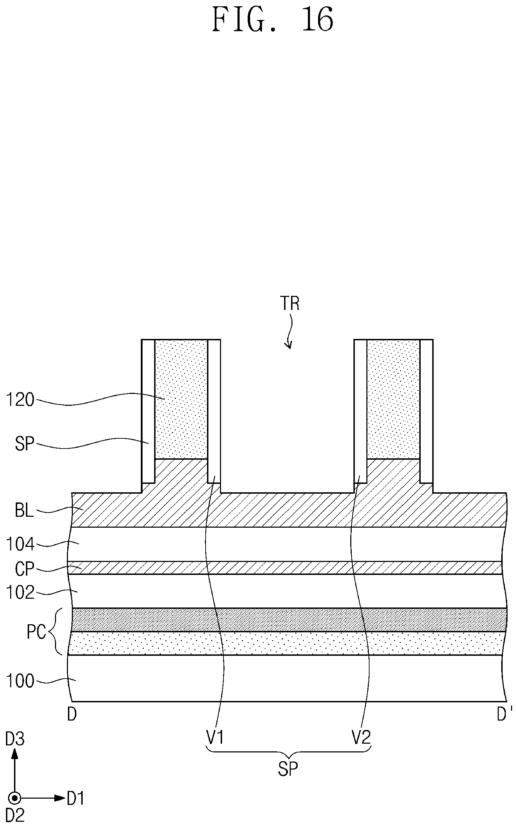

FIG. 16 is a sectional view illustrating a method of fabricating the semiconductor device of FIG. 11A.

Referring to FIGS. 3 and 16, portions of the semiconductor layer SL, which are located on the top surface of the first insulating pattern 120 and the top surface of the bit line BL in the trench region TR, may be removed after the step of FIG. 13C. The semiconductor layer SL may be divided into a plurality of semiconductor patterns SP by the removal step. Each of the semiconductor patterns SP may include the first and second vertical portions V1 and V2, which are opposite to each other and are spaced apart from each other. The semiconductor pattern SP may not include the horizontal portion H.

A portion of the bit line BL in the trench region TR may be further removed through the removal process, and a portion of the top surface of the bit line BL may be exposed to the outside. The exposed top surface of the bit line BL may be located at a height lower than the bottommost surfaces of the first and second vertical portions V1 and V2.

Thereafter, the steps described with reference to FIGS. 13D, 13E, and 7A may be performed to form the semiconductor device of FIG. 11A.

Although not shown, in the case where the steps described with reference to FIGS. 14A and 14B are performed before the step described with reference to FIG. 16, the semiconductor device of FIG. 12A may be formed.

Although not shown, before the formation of the first insulating layer 125 of FIG. 13A, an auxiliary layer may be formed to cover the entire top surface of the substrate 100, and as a result, the semiconductor device of FIGS. 11B to 11D and 12B to 12D may be formed.

According to an example embodiment of the inventive concepts, a word line may be provided to effectively control a lower portion of a channel region, and as a result, electrical and reliability characteristics of a semiconductor device may be improved.

According to an example embodiment of the inventive concepts, a contact resistance between a bit line and a semiconductor pattern may be reduced, and thus, the electrical and reliability characteristics of the semiconductor device may be improved.

While example embodiments of the inventive concepts have been particularly shown and described, it will be understood by one of ordinary skill in the art that variations in form and detail may be made therein without departing from the scope of the attached claims.

## Claims

1. A semiconductor device, comprising:
a bit line extending in a first direction;
a semiconductor pattern on the bit line, the semiconductor pattern comprising first and second vertical portions, which are opposite to each other in the first direction,;
first and second word lines adjacent to the first and second vertical portions, respectively; and
a gate insulating pattern between the first vertical portion and the first word line and between the second vertical portion and the second word line,
wherein a bottom surface of the first and second vertical portions is located at a height that is lower than or equal to an uppermost surface of the bit line.

2. The semiconductor device of claim 1, wherein the semiconductor pattern includes a horizontal portion connecting the first and second vertical portions and wherein a bottom surface of the horizontal portion is located at a height that is lower than or equal to an uppermost surface of the bit line.

3. The semiconductor device of claim 1, wherein a bottom surface of the first and second vertical portions is located at a height higher than a bottom surface of the gate insulating pattern.

4. The semiconductor device of any preceding claim, wherein
the semiconductor pattern comprises a first semiconductor pattern and a second semiconductor pattern adjacent to each other in the first direction,
the semiconductor device further comprises a lower pattern between the first and second semiconductor patterns, and
the lower pattern contains at least one of hydrogen and deuterium.

5. The semiconductor device of claim 2, wherein at least a portion of the horizontal portion is received in an upper portion of the bit line.

6. The semiconductor device of any preceding claim, wherein
the semiconductor pattern comprises a first semiconductor pattern and a second semiconductor pattern adjacent to each other in the first direction,
the semiconductor device further comprises an auxiliary pattern between the first and second semiconductor patterns,
the auxiliary pattern comprises at least one of a blocking pattern and a lower pattern,
the blocking pattern comprises at least one of insulating and conductive materials, and
the lower pattern contains at least one of hydrogen and deuterium.

7. The semiconductor device of claim 6, wherein a bottom surface of the first and second vertical portions is located at a height that is lower than or equal to a lowermost surface of the auxiliary pattern.

8. The semiconductor device of claim 6 or 7, wherein
the auxiliary pattern comprises both of the blocking pattern and the lower pattern, and
the lower pattern is between the bit line and the blocking pattern.
